# EUROPÄISCHE PATENTSCHRIFT

(11) **EP 3 433 207 B1**
(45) Veröffentlichungstag und Bekanntmachung des Hinweises auf die Patenterteilung: **13.08.2025**
(21) Anmeldenummer: 17714164.5
(22) Anmeldetag: 21.03.2017
(51) Int. Cl.: B81C 1/00, G02B 26/08, G02B 7/00

(54) **VERFAHREN ZUR HERSTELLUNG OPTISCHER KOMPONENTEN UNTER VERWENDUNG VON FUNKTIONSELEMENTEN**
METHOD FOR PRODUCING OPTICAL COMPONENTS, USING FUNCTIONAL ELEMENTS
PROCÉDÉ DE FABRICATION DE COMPOSANTS OPTIQUES AU MOYEN D'ÉLÉMENTS FONCTIONNELS

(30) Priorität: 23.03.2016 DE 102016105440
(43) Veröffentlichungstag der Anmeldung: 30.01.2019
(73) Patentinhaber: Fraunhofer-Gesellschaft zur Förderung der angewandten Forschung e.V., 80686 München (DE)
(72) Erfinder: QUENZER, Hans, Joachim, 25524 Itzehoe (DE); STENCHLY, Vanessa, 25704 Meldorf (DE)
(86) Internationale Anmeldenummer: PCT/EP2017/056627
(87) Internationale Veröffentlichungsnummer: WO 2017/162628

(56) Entgegenhaltungen:
- EP-A1- 0 709 881
- EP-A2- 0 245 677
- DE-A1- 102010 062 118
- JP-A- 2002 299 647
- US-A- 5 119 240
- US-A1- 2001 022 382
- US-A1- 2013 285 169
- US-A1- 2015 040 368

## Beschreibung

### Technisches Gebiet

Die Erfindung betrifft ein Verfahren zur Herstellung von optischen Komponenten, insbesondere Deckeln zur Verkapselung von Mikro-Systemen, die insbesondere eine optische Funktion zu erfüllen haben.

Ein Deckel zur Verkapselung von Mikro-Systemen (z.B. MOEMS, MEMS), die üblicherweise auf einem Trägersubstrat angeordnet sind, soll in der Regel mindestens einen Schutz gegen Verunreinigungen bieten und gleichzeitig die mechanische und/oder optische Funktionalität der Mikro-Systeme nicht beeinträchtigen. Sollte die Funktionalität der Mikro-Systeme nicht nur auf Bewegungen in der beziehungsweise parallel zur Trägersubstratebene beschränkt sein, sondern auch Bewegungen senkrecht zur Trägersubstratebene vorsehen, muss ein Deckel den Mikro-Systemen üblicherweise entsprechende Bewegungsfreiheit gewährleisten. Dies erfordert Strukturierungsverfahren, die zum Beispiel eine hohe Oberflächenqualität der optisch funktionalen Bereiche gewährleistet.

### Stand der Technik

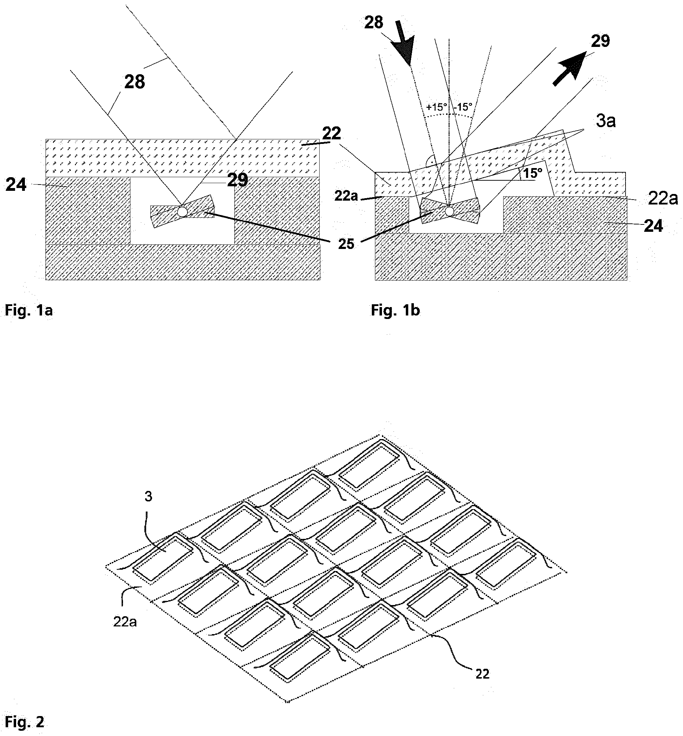

Sollen die Mikro-Systeme eine optische Funktion ausüben oder sollen bestimmte Parameter oder physikalische Größen der Mikro-Systeme optisch gemessen werden - beispielsweise Bestimmung der Auslenkung mittels Interferometer oder durch Auswertung von Videosequenzen - dann bedarf es in der Regel eines optisch transparenten Deckels. (Fig. 1a)

In der WO 2004/1068665 wird ein Wafer-Level-Packaging-Verfahren für MOEMS beschrieben, welches einen Deckel aus Glas vorsieht. Vor dem Verkapselungsprozess wird der Trägerwafer mit den MOEMS allerdings vereinzelt. Die daraus resultierenden separaten ungekapselten Chips (DIEs) werden auf einem neuen Substrat platziert, montiert, kontaktiert und erst anschließend gekapselt. Vertiefungen im Deckel können mit bekannten Präge- und Ätzverfahren und/oder durch den Einsatz von Abstandshaltern, zum Beispiel aus Silizium, erzeugt werden.

In der US6146917 wird ein Wafer-Level-Packaging-Verfahren für MEMS/MOEMS beschrieben, bei dem ein mit Vertiefungen versehener Deckelwafer aus Silizium oder Glas durch Fusions-Bonden oder Anodisches Bonden mit dem Trägerwafer verbunden wird, woraus ein hermetisch dichtes Gehäuse resultiert. Die Herstellung der erforderlichen 50 bis 150 µm tiefen Vertiefungen im Deckelwafer aus Silizium kann durch naßchemisches Ätzen mittels KOH-Lösung erfolgen.

In der US2005/0184304 wird ein Wafer-Level-Packaging-Verfahren zur Verkapselung von oberflächenmikromechanisch gefertigten Mikrospiegel-Arrays vorgestellt. Ein Deckelwafer aus Glas besitzt Vertiefungen, die als optische Fenster dienen und über Vergütungsschichten verfügen können. Die Vertiefungen im Deckelwafer können Tiefen von über 100 µm aufweisen und werden mit gängigen Formgebungsverfahren, wie zum Beispiel Ätzen, Gießen oder Prägen, oder durch den Einsatz von Abstandshaltern erzeugt.

Allen aufgeführten Schriften ist gemein, dass die optischen Fenster des Deckels parallel zur Substratebene des Trägersubstrats (Trägersubstratebene), insbesondere Trägerwafers, und damit zu den darauf angeordneten MEMS/MOEMS ausgeführt sind. Im Stand der Technik werden des Weiteren Deckel mit Vertiefungen, die durch zur Trägersubstratebene geneigt ausgeführte optische Fenster begrenzt sind, beschrieben.

Wie in der WO2007/069165 und in der US 7,948,667 beschrieben, kann durch geneigte optische Fenster eine Reflexionsausblendung (Fig. 1b) erreicht werden.

Nach der US2007/0024549A1 können auch Deckel mit geneigten optischen Fenstern gefertigt werden, die eine Verkapselung auf Wafer-Ebene ermöglichen. Die Formgebung des Deckels beziehungsweise die Realisierung der erforderlichen Vertiefungen erfolgt mit bekannten Präge- und Formgebungsverfahren.

Zu solchen Formgebungsverfahren zählen beispielsweise das Glastiefziehen und das Blankpressen. Insbesondere das Bankpressen wird auch zur Herstellung optischer Komponenten, wie zum Beispiel Linsen, eingesetzt; (siehe Bernd Bresseler, "Mikroproduktion - Der Werkzeugbau als Maß der Dinge" auf der Internetseite http://www.aixtooling.de/index.html?content=/deutsch/aktuelles/aktuelles.html sowie John Deegan Rochester Precision Optics "Precision Glass Molding Technical Brief" auf der Internetseite http://www.rpoptics.com/Precision%20Glass%20Molding%20Technical%20Brief_2.pdf)*.*

Optische Komponenten, die ebene beziehungsweise planparallelen Flächen aufweisen, wie zum Beispiel Spiegel beziehungsweise teildurchlässige Spiegel sowie Strahlteiler (Druckschriften Chuan Pu, Zuhua Zhu and Yu-Hwa Lo "Surface Micromachined Integrated Optic Polarization Beam Splitter"; IEEE PHOTONICS TECHNOLOGY LETTERS, Vol. 10, NO. 7, JULY 1998 sowie Lih Y. Lin and Evan L. Goldstein "Micro-Electro-Mechanical Systems (MEMS) for WDM Optical-Crossconnect Networks", IEEE 1999) werden in der Mikrosystemtechnik üblicherweise aus Silizium hergestellt. So lassen sich beispielsweise durch anisotrope nasschemische Ätzprozesse, zum Beispiel mittels KOH, geneigte Spiegel realisieren (Druckschrift Jenq-Yang Chang, Chih-Ming Wang, Chien-Chieh Lee, Hsi-Fu Shih and Mount-Learn Wu "Realization of Free-Space Optical Pickup Head With Stacked Si-Based Phase Elements"; IEEE PHOTONICS TECHNOLOGY LETTERS).

In der Druckschrift Kyounggsik Yu, Daesung Lee, Uma Krishnamoorthy, Namkyoo Park and Olav Solgaard "Micromachined Fourier transform spectrometer on silicon optical bench platform"; Sensors and Actuators A130-131 (2006) 523-530 werden mikrooptische Strahlteiler und geneigte Spiegel ebenfalls mittels verschiedener Ätzverfahren hergestellt, wobei auf eine hohe Qualität, insbesondere auf eine geringe Rauigkeit, der optisch funktionalen Oberflächen verwiesen wird. Mittels nasschemischer KOH-Ätzung lassen sich in Silizium Oberflächen mit einer quadratischen Oberflächenrauigkeit kleiner 20 nm erreichen. Allerdings können solche Oberflächen in Standardsiliziumwafern nur mit bestimmten Neigungswinkeln, die durch die Kristallstuktur von Silizium vorgegeben sind, realisiert werden.

Die Herstellung optischer Komponenten auf Basis von Glas, wie zum Beispiel Borsilikatglas, mittels Ätzverfahren führt in der Regel zu Oberflächen, deren Rauigkeit für optische Anwendungen nicht zufriedenstellend ist (siehe Druckschriften Xinghua Li, Takashi Abe, Masayoshi Esashi "Deep reactive ion etching of Pyrex glass using SF6 plasma", Sensors and Actuators A87, 2001, pp. 139-145 sowie Ciprian Iliescu, Kwong Luck Tan, Francis E. H. Tay, Jianmin Miao "Deep Wet and Dry Etching of Pyrex Glass: A Review").

Ein Verfahren zur Herstellung von optischen Komponenten, insbesondere von Deckeln mit geneigten optischen Fenstern, wird zudem in der DE102008012384 und in der WO2013/079131 beschrieben. Durch den Einsatz von Verstärkungselementen und mittels Glasfließens lassen sich die als optische Fenster fungierenden Bereiche geschützt und stabilisiert neigen, wodurch sich qualitativ hochwertige geneigte und/oder verschobene optische Fenster realisieren lassen. Ein Nachteil des Verfahrens besteht darin, dass die Strukturierung der Glassubstrate mit einem relativ hohen Materialaufwand verbunden ist, da für die Kraftaufnahme, die Verformung und die optischen Fenster verschiedene Bereiche des Glassubstrats vorgesehen sind.

In der US 2001/0022382 wird des Weiteren ein Verfahren zur Herstellung eines Gehäuses für optische Anwendungen beschrieben, wobei zur Erzielung der Neigung des optischen Fensters eine rahmenförmige Lotschicht durch Abscheidungsprozesse aufgebracht wird.

Die US 2013/0285169 offenbart ein Verfahren zur Herstellung eines Deckels mit einem optischen Fenster zur Verkapselung von MEMS, wobei eine verformbare Schicht aus einem transparenten Material zur Anwendung kommt und die Neigung eines verlagerbaren Bereichs durch Verformung eines Bereichs der verformbaren Schicht, der eine Neigungsachse definiert, bewirkt wird.

Zudem offenbart die EP 0 709 881in Verbindung mit der hermetischen Verkapselung von Halbleitern einen rahmenförmigen Preform, welcher im Rahmen des Verkapselungsprozesses verformt wird.

### Beschreibung

Der vorliegenden Erfindung liegt daher die Aufgabe zugrunde, die Nachteile des Standes der Technik zu überwinden und ein kostengünstiges und flexibleres Verfahren zur Herstellung optischer Komponenten, insbesondere Deckeln, mit verschobenen und/oder geneigten Bereichen und hoher Oberflächenqualität bereitzustellen.

Gemäß der vorliegenden Erfindung wird die Aufgabe durch ein Verfahren nach Anspruch 1 zur Herstellung optischer Komponenten, insbesondere eines Deckels, gelöst. Die Unteransprüche lehren vorteilhafte Weiterbildungen.

Das erfindungsgemäße Verfahren nach Anspruch 1 dient der Herstellung optischer Komponenten, bei denen ein oder mehrere Bereiche beziehungsweise Flächen, insbesondere Oberflächen, die eine optische Funktion zu erfüllen haben, geneigt und/oder verschoben in Bezug auf einen Referenzbereich beziehungsweise eine Referenzfläche der hergestellten optischen Komponente oder einer in der Anwendung, für die die optische Komponente vorgesehen ist, eingesetzten Komponente ausgeführt sind, wobei der Referenzbereich beziehungsweise die Referenzfläche insbesondere auch eine optische Funktion zu erfüllen hat. Insbesondere ist das erfindungsgemäße Verfahren auf Waferebene anwendbar, wodurch mehrere optische Komponenten parallel herstellbar sind.

Die optische Komponente weist insbesondere mindestens ein optisches Element wie zum Beispiel ein optisches Fenster, einen Spiegel beziehungsweise teildurchlässigen Spiegel, einen Strahlteiler, ein Prisma, eine Linse und/oder einen Interferenzfiltern auf, oder die optische Komponente besteht aus mindestens einem optischen Element.

Die Oberflächen eines optischen Fensters, durch die die in der Anwendung eingesetzte Strahlung in das optische Fenster einfällt und/oder wieder ausgekoppelt wird, stellen die Transmissionsflächen eines optischen Fensters dar.

Das erfindungsgemäße Verfahren kann beispielsweise zur Herstellung eines Deckels mit einem oder mehreren optischen Fenstern zur Verkapselung von Mikro-Systemen, die insbesondere eine optische Funktion zu erfüllen haben und üblicherweise auf einem Trägersubstrat aufgebracht oder angeordnet sind, verwendet werden. Häufig findet als Trägersubstrat ein Siliziumwafer Anwendung, auf dem durch oberflächenmikromechanische oder volumenmikromechanische Prozesse die zu verkapselnden Mikro-Systeme (zum Beispiel MEMS, MOEMS) erzeugt werden.

Das erfindungsgemäße Verfahren nach Anspruch 1 zur Herstellung einer oder mehrerer optischer Komponenten, insbesondere mikrooptischer Komponenten, weist die in Anspruch 1 aufgeführten Verfahrensschritte auf, darunter:
- Bereitstellen eines Verformungselements, das zumindest in einem Bereich Glas und/oder ein glasähnliches Material enthält oder daraus besteht, und eines Trägers,
- in Kontakt bringen des Verformungselements mit dem Träger, wodurch eine erste Kontaktfläche zwischen dem Verformungselement und dem Träger gebildet wird,
- Aufbringen eines Funktionselements auf dem Verformungselement derart, dass zwischen dem Funktionselement und dem Verformungselement eine zweite Kontaktfläche gebildet wird, die die erste Kontaktfläche zumindest teilweise überlappt, so dass durch den Bereich des Verformungselements, der zwischen den sich überlappenden Bereichen der beiden Kontaktflächen ausgebildet ist, ein Verformungsbereich gebildet wird,
- Erwärmen und Verformen zumindest eines Teils des Verformungsbereichs derart, dass sich das Funktionselement in Relation zum Träger zumindest bereichsweise verschiebt und/oder neigt,
- Verbinden des Funktionselements mit dem Verformungselement beim Verfahrensschritt des Aufbringens des Funktionselements auf dem Verformungselement und/oder beim Verfahrensschritt des Erwärmen und Verformens des Verformungsbereichs, wobei das Verformungselement ein Wafer ist oder das Verformungselement durch Abtrennen und/oder durch Strukturieren von einem Wafer bereitgestellt wird und wobei der Verformungsbereich rahmenförmig ausgebildet ist und/oder mindestens zwei Verformungsbereiche ausgebildet sind, die mit demselben Funktionselement in Kontakt sind, und/oder der überlappende Bereich der zweiten Kontaktfläche etwa der zweiten Kontaktfläche entspricht.

Das Verformungselement stellt ein zentrales Element für die Herstellung der optischen Komponente dar. Durch die Verformung des Verformungselements beziehungsweise des Verformungsbereichs kann die Ausrichtung beziehungsweise die Position des Funktionselements im Vergleich zu seiner Ausgangslage beziehungsweise in Relation zum Träger geändert werden, ohne dass das Funktionselement einer Verformung unterworfen wird. Dadurch kann beispielsweise eine hohe optische Qualität des Funktionselements erhalten werden. Die Auslenkung des Funktionselements wird zumindest zum Teil durch die Verformung des Verformungselements beziehungsweise des Verformungsbereichs bedingt und nicht nur durch eine Lageänderung des gesamten Verformungselements und/oder des Trägers.

Zudem kann durch die Verformung des Verformungselements dessen Ausgangsform gezielt modifiziert und in eine gewünschte Endform gebracht werden.

Das Verformungselement ist insbesondere ein Substrat, wodurch sich eine Vielzahl von optischen Komponenten parallel herstellen lässt, oder ein Strukturelement, wodurch Verformungselemente mit speziellen Geometrien, zum Beispiel in Form eines Rahmens (rahmenförmige Struktur), bereitgestellt werden können.

Eine Vielzahl optischer Komponenten sollte zumindest in Bereichen, üblicherweise in ihrer Gesamtheit, für die in der Anwendung eingesetzte elektromagnetische Strahlung durchlässig sein. Bei den meisten optischen Anwendungen wird eine möglichst hohe Transparenz der Bereiche, die für die in der Anwendung eingesetzte elektromagnetische Strahlung durchlässig sein sollen, gefordert, damit beispielsweise ein Laserstrahl möglichst unbeeinflusst das Mikro-System erreicht.

Entsprechend enthält das Verformungselement zumindest in einem Bereich Glas und/oder ein glasähnliches Material oder das Verformungselement besteht aus Glas und/oder einem glasähnlichen Material. Unter glasähnlichen Materialien werden erfindungsgemäß Stoffe verstanden, die wegen ihrer thermodynamischen Eigenschaften (amorpher Aufbau, Glasübergangstemperatur) Gläsern ähneln, obwohl sich ihre chemische Zusammensetzung von der der Silikatgläser unterscheidet. Als Beispiele seien hier die in der Chemie bekannten Kunstgläser oder organischen Vitroide wie Polymethylmethacrylate (PMMA), Polycarbonat und Polystyrol genannt.

Geeignete Gläser sind beispielsweise Silikatgläser, insbesondere Borsilikatgläser, da Borsilikatgläser sehr chemikalien- und temperaturbeständig sind. Die Temperaturbeständigkeit und Unempfindlichkeit der Borsilikatgläser gegen plötzliche Temperaturschwankungen sind eine Folge ihres geringen Wärmeausdehnungskoeffizienten. Zudem ist der Transmissionsgrad insbesondere im für den Menschen sichtbaren Wellenlängenbereich mit über 90% sehr hoch.

Neben ein oder mehreren Verformungselementen wird mindestens ein Träger bereitgestellt, der das Verformungselement zumindest bereichsweise stützt und eine stabile Kraftaufnahme, insbesondere auch während des Erwärmen und Verformens, gewährleistet.

Der Träger ist insbesondere ein Substrat, bevorzugt ein Siliziumwafer, oder eine andere flächige Auflage (zum Beispiel ein Werkzeug oder eine Tischplatte), die ein oder mehrere Verformungselemente aufnehmen kann und so eine optimierte serielle und/oder parallele Bearbeitung ermöglicht, wodurch die Effizienz des Herstellungsverfahrens erhöht werden kann.

Der Träger enthält bevorzugt zumindest in einem Bereich ein halbleitendes Material oder der Träger besteht aus einem halbleitenden Material, insbesondere Silizium. So können Halbleiterwafer, beispielsweise Siliziumwafer, als Träger Verwendung finden, wodurch die ausgereiften und gut beherrschbaren Prozesse der Halbleitertechnologie, insbesondere der Siliziumtechnologie, einsetzbar sind.

Der Träger - insbesondere ein oder mehrere Bereiche des Trägers, die mit dem Verformungselement in Kontakt gebracht werden - weist insbesondere eine Antihaftglasur, die insbesondere ein Silikat und Aluminiumhydroxid enthält, auf und/oder der Träger ist beschichtet mit beziehungsweise enthält insbesondere hochtemperaturbeständige Materialien, insbesondere Graphit, Titanaluminiumnitrid, Bornitrid, Siliziumcarbid, ein Edelmetall, insbesondere Platin, und/oder eine Edelmetalllegierung, insbesondere eine Platin-Indium- oder eine Platin-Iridium-Legierung, oder der Träger beziehungsweise der Bereich besteht daraus. Auf Grund einer geringen Neigung, sich mit dem Verformungselement, insbesondere mit Glas, zu verbinden und einer dadurch bedingten geringen Abnutzung lassen sich solche Träger mehrfach benutzen beziehungsweise über einen längeren Zeitraum einsetzen (längere Standzeit).

In einer weiteren Ausführungsform weist der Träger eine Unterstützungsstruktur auf, die mindestens einen Bereich des Funktionselements und/oder mindestens einen Bereich des Verformungselements derart in seiner Auslenkbarkeit und/oder Verformbarkeit beschränkt, dass ein Neigen des Funktionselements unterstützt beziehungsweise erreicht wird. Dadurch kann eine gezielte beziehungsweise differenzierte Kraftaufnahme gewährleistet werden und damit der Prozess, insbesondere in Bezug auf den zeitlichen Herstellungsaufwand und in Bezug auf die Reproduzierbarkeit der optischen Komponente, optimiert werden. Insbesondere bei einem Kontakt der Unterstützungsstruktur mit dem Funktionselement können Kräfte, die auf das Funktionselement wirken, direkt durch die Unterstützungsstruktur beziehungsweise den Träger aufgenommen und so Bereiche des Verformungsbereichs gezielt entlastet werden.

In einem weiteren Verfahrensschritt wird das Verformungselement mit dem Träger in Kontakt gebracht, wodurch mindestens eine erste Kontaktfläche zwischen dem Verformungselement und dem Träger gebildet wird.

Des Weiteren wird das Funktionselement auf dem Verformungselement derart aufgebracht, dass zwischen dem Funktionselement und dem Verformungselement mindestens eine zweite Kontaktfläche gebildet wird, die die erste Kontaktfläche zumindest teilweise überlappt, so dass durch den Bereich des Verformungselements, der zwischen den sich überlappenden Bereichen der beiden Kontaktflächen ausgebildet ist, mindestens ein Verformungsbereich gebildet wird.

Bezüglich der Chronologie dieser beiden Verfahrensschritte besteht die Möglichkeit, das Verformungselement mit dem Träger in Kontakt zu bringen, bevor oder nachdem das Funktionselement auf dem Verformungselement aufgebracht wird/wurde. Alternativ kann eine zeitgleiche Prozessierung erfolgen.

Das Funktionselement ist ein weiteres Basiselement für die Herstellung der optischen Komponente, wobei das Funktionselement im Ergebnis ein Bestandteil der hergestellten optischen Komponente sein kann und insbesondere eine optische Funktionalität aufweisen kann.

Des Weiteren kann das Funktionselement das Verformungselement beziehungsweise ein oder mehrere Oberflächenbereiche des Verformungselements beim Einsatz von Formgebungsvorrichtungen (zum Beispiel Stempeln) vor zu starker mechanischer Beanspruchung beziehungsweise vor einem direkten Kontakt mit der Formgebungsvorrichtung schützen und/oder eine extern eingebrachte Kraft, zum Beispiel auf Basis einer Druckdifferenz, auf den Verformungsbereich übertragen beziehungsweise verteilen.

Zudem kann das Funktionselement als Abformelement eingesetzt werden, wobei ein oder mehrere Oberflächenbereiche des Funktionselements auf das Verformungselement beziehungsweise auf ein oder mehrere Oberflächenbereiche des Verformungselements abgeformt werden. So lassen sich beispielsweise Strukturen beziehungsweise Eigenschaften eines Oberflächenbereichs des Funktionselements, wie zum Beispiel Rauigkeit und/oder Ebenheit, auf das Verformungselement übertragen.

Das Funktionselement ist insbesondere ein optisches Element, beispielsweise ein optisches Fenster, ein Spiegel, ein teildurchlässiger Spiegel, ein Strahlteiler, ein Prisma, eine Linse und/oder ein Interferenzfilter. Ein solches optisches Element kann beispielsweise vor dem Verfahren separat hergestellt und dann im Rahmen des Verfahrens in die herzustellende optische Komponente integriert werden. Die Trennung zwischen Herstellung und Integration des optischen Elements ermöglicht eine zumindest teilweise unabhängige Optimierung beider Prozesse und eine hohe Qualität der optischen Komponente, insbesondere durch Erhalt der optischen Qualität des optischen Elements.

Um eine hohe Qualität der optischen Komponente, insbesondere der Oberflächen, zu gewährleisten, weist zumindest ein Bereich der Oberfläche des Funktionselements, insbesondere ein Bereich, der als Transmissionsfläche fungieren und/oder mit dem Verformungselement in Kontakt gebracht werden soll, insbesondere eine quadratische Oberflächenrauigkeit kleiner gleich 25nm, bevorzugt kleiner gleich 15nm, besonders bevorzugt kleiner gleich 5nm und/oder insbesondere eine Ebenheitsabweichung pro gemessener Länge (relative Ebenheitsabweichung) kleiner gleich 180 nm/mm, bevorzugt kleiner gleich 100 nm/mm, auf. Dies kann beispielsweise durch Polieren des Bereichs erreicht werden.

Vorzugsweise ist das Funktionselement ein optisches Fenster mit mindestens zwei Transmissionsflächen, wobei die Transmissionsflächen eben (plan) und/oder zueinander parallel ausgeführt sind.

Um optischen Qualitätsansprüchen gerecht zu werden, weisen die Transmissionsflächen bevorzugt eine relative Ebenheitsabweichung kleiner gleich einem Viertel der Wellenlänge der in der Anwendung eingesetzten elektromagnetischen Strahlung pro Millimeter auf, wobei besonders bevorzugt Wellenlängen vom ultravioletten bis in den infraroten Wellenlängenbereich (zum Beispiel zwischen etwa 200 nm und etwa 15 µm) Anwendung finden. Um ein breites Anwendungsspektrum abzudecken, weisen die Transmissionsflächen bevorzugt eine relative Ebenheitsabweichung kleiner gleich 180 nm/mm, besonders bevorzugt kleiner gleich 100 nm/mm auf.

Zudem weisen die Transmissionsflächen bevorzugt eine Planparallelitätsabweichung pro gemessener Länge (relative Planparallelitätsabweichung) kleiner gleich 10 µm/mm auf. Mit solchen Oberflächeneigenschaften bietet das Funktionselement, insbesondere das optische Fenster, beste Voraussetzungen für eine optische Komponente (zum Beispiel ein Deckel), die geringere Abweichungen und eine geringere Strahlaufweitung des optischen Strahlenverlaufs verursacht, was zu einer geringeren Verfälschung der optischen Signale führt.

Die Werte für die Ebenheits- und Planparallelitätsabweichung sowie für die quadratische Oberflächenrauigkeit wurden mittels interferometrischer Messmethode bestimmt. Für die Messungen wurde das Weißlicht- und Phaseninterferometer MicroMap 512 der Firma Atos oder VEECO Wyko NT 1100 der Firma Veeco verwendet.

Des Weiteren sollte das Funktionselement vorzugsweise eine homogene Materialstruktur aufweisen, um unerwünschte Brechungen und/oder Ablenkungen der Strahlung zu vermeiden.

Eine Vielzahl von optischen Komponenten sollte zumindest in einem Bereich, insbesondere in ihrer Gesamtheit, für die in der Anwendung eingesetzte elektromagnetische Strahlung durchlässig sein. Entsprechend enthält das Funktionselement insbesondere zumindest in einem Bereich Glas und/oder ein glasähnliches Material oder das Funktionselement besteht aus Glas und/oder einem glasähnlichen Material.

Geeignete Gläser sind insbesondere Silikatgläser (zum Beispiel Borsilikatglas) mit und ohne Erdalkalizusätzen, wie zum Beispiel Eagle XG^{®} (Corning), Hoya SD 2^{®} (Hoya) und AF 32^{®} (Schott), da diese Gläser sehr chemikalien- und temperaturbeständig sind. Die Temperaturbeständigkeit und Unempfindlichkeit dieser Gläser gegen plötzliche Temperaturschwankungen sind eine Folge ihres geringen Wärmeausdehnungskoeffizienten. Zudem ist der Transmissionsgrad insbesondere im für den Menschen sichtbaren Wellenlängenbereich mit über 90% sehr hoch.

In einer weiteren Ausführungsform enthält das Funktionselement zumindest in einem Bereich ein halbleitendes Material, insbesondere Silizium, oder das Funktionselement besteht daraus, wodurch die ausgereiften und gut beherrschbaren Prozesse der Halbleitertechnologie, insbesondere der Siliziumtechnologie, eingesetzt werden können. Zudem weist insbesondere Silizium für Infrarotstrahlung bei geeigneter Entspiegelung einen Transmissionsgrad von über 90% auf.

Besonders geeignete Materialien für das Funktionselement weisen einen thermischen Ausdehnungskoeffizienten auf, der dem thermischen Ausdehnungskoeffizienten des Materials des Verformungselements möglichst nahe kommt beziehungsweise mit diesem möglichst identisch ist. Bevorzugt sollte die Differenz des thermischen Ausdehnungskoeffizienten des Materials des Verformungselements und des thermischen Ausdehnungskoeffizienten des Materials des Funktionselements kleiner gleich 5 ppm/°K, besonders bevorzugt kleiner gleich 1 ppm/°K, sein. Dadurch lassen sich mechanische Spannungen, die während des Abkühlens durch unterschiedlich starkes Zusammenziehen des Materials des Verformungselements beziehungsweise des Verformungsbereichs und des Materials des Funktionselements entstehen können und die zu einer Beschädigung des Verformungselements und/oder des Funktionselements beziehungsweise der optischen Komponente führen könnten, reduzieren.

Beim Inkontaktbringen des Verformungselements mit Träger und/oder beim Aufbringen des Funktionselements auf dem Verformungselement werden das Verformungselement und der Träger beziehungsweise das Funktionselement und das Verformungselement bevorzugt miteinander verbunden, besonders bevorzugt formschlüssig und/oder stoffschlüssig, insbesondere durch Kleben, Löten oder Bonden, um eine hohe Lagestabilität des Verformungselements gegenüber dem Träger und/oder des Funktionselements gegenüber dem Verformungselement zu gewährleisten.

In einer bevorzugten Ausführungsform wird eine formschlüssige Verbindung zwischen dem Funktionselement und dem Verformungselement dadurch realisiert, dass das Funktionselement in einer Justiervertiefung des Verformungselements, die für die Aufnahme des Funktionselements ausgebildet ist, angeordnet wird. In äquivalenter Weise kann zwischen dem Verformungselement und dem Träger eine formschlüssige Verbindung durch Anordnung des Verformungselements in einer dafür ausgebildeten Justiervertiefung des Trägers hergestellt werden. Bei dieser Art der Anordnung sind keine zusätzlichen Verbindungssubstanzen (zum Beispiel Klebstoff) beziehungsweise spezielle Verbindungsschritte (zum Beispiel Bonden) erforderlich, die die Oberflächenqualität insbesondere des Funktionselements und/oder des Verformungselements beeinträchtigen könnten.

In einer weiteren Ausführungsform erfolgt das Inkontaktbringen des Verformungselements mit dem Träger und/oder das Aufbringen des Funktionselements auf dem Verformungselement durch anodisches Bonden, direktes Bonden, Fusion-Bonding, plasma-aktiviertes Bonden und/oder thermisches Bonden. Vor allem in der Halbleiterindustrie sind diese Bondverfahren häufig eingesetzte Verbindungstechniken, die zu stabilen Verbindungen führen. Ein solcher Verbindungsschritt erfolgt insbesondere im Vakuum, wodurch sich beispielsweise Lufteinschlüsse und/oder eingeschlossene Partikel in den Verbindungsbereichen, insbesondere an der Grenzfläche zwischen dem Verformungselement und dem Träger und/oder dem Verformungselement und dem Funktionselement, und dadurch entstehende Defekte insbesondere in den Grenzflächenbereichen des Funktionselements und/oder des Verformungselements reduzieren lassen.

Beim Aufbringen des Funktionselements auf dem Verformungselement wird das Funktionselement bevorzugt von einem Funktionssubstrat abgetrennt beziehungsweise aus einem Funktionssubstrat herausgetrennt und insbesondere nachfolgend in Kontakt mit dem Verformungselement gebracht beziehungsweise auf diesem angeordnet und insbesondere mit diesem verbunden.

Das Funktionssubstrat ist insbesondere als Platte oder Wafer, beispielsweise als Siliziumoder Glaswafer, ausgeführt. Dadurch lassen sich aus einem oder mehreren Funktionssubstraten eine Vielzahl von Funktionselementen herstellen und die Bearbeitungsschritte zum Beispiel für die Gewährleistung der gewünschten Stärke beziehungsweise Dicke der Funktionselemente reduzieren beziehungsweise optimieren.

Bevorzugte Trennverfahren sind Bohren, Sägen, Fräsen, Laserschneiden beziehungsweise Laserbearbeiten, Brechen (eventuell mit vorherigem Ritzen), Sandstrahlen und/oder Ätzen.

Durch einen vor dem Anordnen des Funktionselements auf dem Verformungselement stattfindenden Herstellungsprozess kann das Ausgangsmaterial (Funktionssubstrat) für das Funktionselement effektiver genutzt werden. Dadurch und durch die damit verbundene Einsparung von weiteren Prozessschritten, wie zum Beispiel Lackaufbringung, Belichtung, Lackstrukturierung, Lackentfernung, lassen sich die Fertigungskosten reduzieren.

Die Herstellung von Funktionselementen vor dem Anordnen auf dem Verformungselement hat zudem den Vorteil, dass Funktionselemente aus verschiedenen Materialien (zum Beispiel von mehreren Funktionssubstraten) und mit unterschiedlichen Größen (zum Beispiel Dicken) beziehungsweise Formen sowie mit verschiedenen Eigenschaften (zum Beispiel bezüglich Transparenz, Reflektivität oder Absorptionsverhalten) für den nachfolgenden Anordnungsschritt bereitgestellt werden können. Dies ermöglicht eine optimierte und flexible Anpassung der Fertigung an die gewünschten Spezifikationen.

Des Weiteren wird bei einer Herstellung des Funktionselements vor dem Anordnen auf dem Verformungselement der Bereich des Verformungselements, der nicht mit dem Funktionselement in Kontakt beziehungsweise in Verbindung gebracht werden soll, in geringerem Maße aggressiven Medien wie zum Beispiel Ätzlösungen ausgesetzt, so dass eine hohe Oberflächenqualität dieses Bereichs besser erhalten und für spätere Kontaktierungs- und/oder Verbindungsschritte konserviert werden kann.

Zudem können insbesondere komplexere Funktionselemente beziehungsweise mit speziellen Herstellungsverfahren gefertigte Funktionselemente (zum Beispiel Linsen, Prismen) verwendet werden.

Das Anordnen des Funktionselements auf dem Verformungselement kann beispielsweise mit einem Vakuumhandler (Vakuumsauger), einem Greifer (Collet) oder einem Pickup-Tool (Kombination aus Vakuumsauger und Greifer) erfolgen, die eine positionsgenaue und präzise Anordnung des Verformungselements beziehungsweise des Funktionselements gewährleisten.

In einer weiteren Ausführungsform wird das mindestens eine Funktionselement vor dem Anordnen auf dem Verformungselement auf einem Positionierungsmittel angeordnet. Die Bestückung des Positionierungsmittels, also die Übertragung und Anordnung des Funktionselements auf das/dem Positionierungsmittel, kann beispielsweise mit einem Vakuumhandler (Vakuumsauger), einem Greifer (Collet) oder einem Pickup-Tool (Kombination aus Vakuumsauger und Greifer) erfolgen, die eine positionsgenaue und präzise Bestückung auf dem Positionierungsmittel gewährleisten.

Als Positionierungsmittel eignen sich alle Mittel, Vorrichtungen und Werkzeuge, die das Funktionselement in seiner Lage stabilisieren beziehungsweise justiert halten. Durch diese Stabilisierung wird die Handhabung in Bezug auf die weiteren Verfahrensschritte wesentlich erleichtert. So kann beispielsweise die Bestückung unter Reinraumbedingungen bei atmosphärischem Luftdruck und ein nachfolgender Verbindungsschritt, zum Beispiel das anodische Bonden, in einem anderen Reimraumbereich im Vakuum erfolgen.

Als Positionierungsmittel geeignet sind beispielsweise haftfähige Unterlagen auf Basis von magnetischer oder elektrostatischer Kraftwirkung oder Substrate, die kraftschlüssige (zum Beispiel die Reibung erhöhende Schicht), stoffschlüssige (zum Beispiel aufgebrachte Klebeschicht) oder formschlüssige Verbindungen (zum Beispiel Vertiefungen beziehungsweise Ausnehmungen) gewährleisten können.

Mit Blick auf einen nachfolgenden Verbindungsschritt (zum Beispiel anodisches Bonden) ist das Positionierungsmittel bevorzugt elektrisch leitfähig ausgeführt. Entsprechend enthält oder besteht das Positionierungsmittel insbesondere aus elektrisch leitfähigen und/oder halbleitenden Materialien, wie zum Beispiel Silizium.

Als geeignetes Positionierungsmittel kann ein Aufnahmesubstrat Verwendung finden. Ein solches Aufnahmesubstrat verfügt über mindestens eine Ausnehmung beziehungsweise Vertiefung (Aufnahmevertiefung), die für die Aufnahme eines oder mehrerer Funktionselemente ausgelegt ist und dieses insbesondere lateral fixiert beziehungsweise justiert hält. Da die Justage in diesem Fall im Wesentlichen durch eine formschlüssige Verbindung zwischen Aufnahmesubstrat und Funktionselement gewährleistet wird, kann das Aufnahmesubstrat nach dem Anordnen des Funktionselements auf dem Verformungselement durch Aufhebung des Formschlusses auf einfache Art und Weise entfernt werden, um die so erzeugte Anordnung für weitere Prozessschritte freizugeben. Das Aufnahmesubstrat lässt sich dann für den nächsten Bestückungsvorgang wieder verwenden und ist so mehrfach einsetzbar, wodurch wiederum eine Reduzierung des Fertigungsaufwandes und der Fertigungskosten gegeben ist.

Zudem oder alternativ kann das Funktionselement, wie zum Beispiel ein optisches Fenster, derart auf dem Verformungselement erzeugt werden, dass mindestens eine Funktionsschicht auf dem Verformungselement aufgebracht wird. Die Funktionsschicht kann beispielsweise mittels Abscheideverfahren und/oder durch Verwendung eines Funktionssubstrates (zum Beispiel ein Siliziumwafer oder ein Glassubstrat) erzeugt werden. Dabei wird die Funktionsschicht mit dem Verformungselement bevorzugt verbunden, insbesondere stoffschlüssig (zum Beispiel mittels Bonden, Löten, Kleben oder Abscheiden), um eine hohe Lagestabilität der Funktionsschicht und dem daraus erzeugten Funktionselement zu gewährleisten.

Zweckmäßig erfolgt das Aufbringen der Funktionsschicht auf dem Verformungselement derart, dass ein Verschieben und/oder Verdrehen der Funktionsschicht gegenüber dem Verformungselement reduziert oder verhindert wird.

Bevorzugt wird als Funktionsschicht eine Polysiliziumschicht insbesondere mittels CVD, insbesondere Hot Wire-CVD oder PECVD, oder PVD, insbesondere Sputtern, auf dem Verformungselement aufgebracht. Da die Prozesstemperaturen bei diesen Abscheideverfahren unter 600°C, insbesondere zwischen 400°C und 500°C, liegen, lassen sich damit auch temperaturempfindlichere Verformungselemente beschichten. Des Weiteren kann die Funktionsschicht in Form eines Funktionssubstrats, zum Beispiel ein Siliziumwafer, durch anodisches Bonden und/oder thermisches Bonden auf dem Verformungselement aufgebracht beziehungsweise mit diesem verbunden werden. Vor allem in der Halbleiterindustrie sind diese Bondverfahren häufig eingesetzte Verbindungstechniken, die zu stabilen Verbindungen führen.

Nachdem die Funktionsschicht aufgebracht wurde, wird diese zur Erzeugung des mindestens einen Funktionselements insbesondere mittels Bohren, Sägen, Fräsen, Laserschneiden, Brechen, Sandstrahlen und/oder Ätzen strukturiert.

Das durch Abtrennen vom Funktionssubstrat hergestellte mindestens eine Funktionselemente wird derart auf dem Verformungselement angeordnet beziehungsweise mit diesem verbunden und/oder durch die Strukturierung der Funktionsschicht werden ein oder mehrere Funktionselemente derart erzeugt, dass diese durch die insbesondere nachfolgende Verformung des Verformungsbereichs auslenkbar sind. Zudem wird durch die Anordnung beziehungsweise Verbindung und/oder die Strukturierung insbesondere die Form der zweiten Kontaktfläche gestaltet und damit der Überlappungsbereich eingestellt.

Die vorher beschriebenen Ausführungen zum Aufbringen des Funktionselements auf dem Verformungselement gelten äquivalent für das Inkontaktbringen des Verformungselements mit dem Träger. Entsprechend kann das Verformungselement vor dem Inkontaktbringen hergestellt (zum Beispiel von einem Verformungssubstrat abgetrennt beziehungsweise herausgetrennt) und anschließend auf dem Träger angeordnet werden, und/oder das Verformungselement wird durch Aufbringen und Strukturieren einer Verformungsschicht auf dem Träger erzeugt.

Die Verwendung sowohl eines Verformungselements als auch eines Funktionselements ermöglicht eine voneinander unabhängige Herstellung und damit eine individuelle Anpassung dieser Elemente an den Prozessablauf beziehungsweise die Spezifikationen, insbesondere für die optische Komponente. Dadurch können beispielsweise Oberflächen - zum Beispiel Transmissionsflächen, die für eine Bearbeitung (zum Beispiel einem Polierschritt) beispielsweise nach dem Erwärmen und Verformen nicht mehr beziehungsweise nur schwer zugänglich sind, bei der Herstellung des entsprechenden Elements (zum Beispiel des Funktionselements) mit einer hohen Oberflächenqualität realisiert werden.

Dass eine erste Schicht, ein erster Bereich oder eine erste Vorrichtung "auf" einer zweiten Schicht, einem zweiten Bereich oder einer zweiten Vorrichtung angeordnet oder aufgebracht ist, kann dabei hier und im Folgenden bedeuten, dass die erste Schicht, der erste Bereich oder die erste Vorrichtung unmittelbar in direktem mechanischen und/oder elektrischen Kontakt auf der zweiten Schicht, dem zweiten Bereich oder der zweiten Vorrichtung angeordnet oder aufgebracht ist. Weiterhin kann auch ein mittelbarer Kontakt bezeichnet sein, bei dem weitere Schichten, Bereiche und/oder Vorrichtungen zwischen der ersten Schicht, dem ersten Bereich oder der ersten Vorrichtung und der zweiten Schicht, dem zweiten Bereich oder der zweiten Vorrichtung angeordnet sind.

In einer weiteren Ausführungsform weist das Funktionselement, das Verformungselement und/oder der Träger ein oder mehrere Vertiefungen und/oder Öffnungen auf, die insbesondere mittels Bohren, Sägen, Fräsen, Laserschneiden, Sandstrahlen und/oder Ätzen erzeugt werden. Erfindungsgemäß stellt ein Loch ebenfalls eine Öffnung dar.

Die Vertiefung und/oder Öffnung kann nach dem Inkontaktbringen des Trägers mit dem Verformungselement und/oder dem Aufbringen des Funktionselements auf dem Verformungselement im Bereich der Vertiefung und/oder Öffnung einen Abstand zwischen dem Träger und dem Verformungselement, zwischen dem Funktionselement und dem Verformungselement beziehungsweise zwischen dem Funktionselement und dem Träger bedingen, um einen Kontakt der Oberflächen in diesem Bereich zu vermeiden und so die Oberflächenqualität (zum Beispiel in Bezug auf die Rauigkeit) dieser Oberflächenbereiche, insbesondere des Funktionselements, zu konservieren. Ein solcher Kontakt könnte zudem insbesondere beim Erwärmen und Verformen zu einem Anhaften des Funktionselements am Verformungselement und/oder Träger beziehungsweise des Verformungselements am Träger führen und ein verformungsbedingtes Auslenken des Funktionselements verhindern oder erschweren.

Um ein möglichst problemloses verformungsbedingtes Auslenken des Funktionselements gewährleisten zu können, sollten vorzugsweise die Bereiche des Funktionselements, die für die Bildung der Überlappungsbereiche nicht relevant sind, insbesondere vor dem Verformen des Verformungsbereichs nicht in direktem oder indirektem (zum Beispiel durch ein oder mehrere zwischengelagerte Schichten bedingt) Kontakt mit dem Verformungselement und/oder dem Träger stehen, um ein Anhaften des Funktionselements am Verformungselement und/oder dem Träger in diesen Bereichen zu verhindert.

Um die Haftkräfte im Falle eines Kontaktes zu verringern, können die Oberflächen beziehungsweise die entsprechenden Oberflächenbereiche des Funktionselements, des Verformungselements und/oder des Trägers mit verschiedenen Beschichtungen versehen und/oder durch Verfahren zur Oberflächenmodifikation (zum Beispiel Nanotexturierung) präpariert werden. Geeignete Beschichtungsmaterialien sind beispielsweise Platin, Platin-Legierungen (zum Beispiel Platin-Iridium-Legierung), NiAlN, Graphit und Bornitrid. Zudem kann die Vertiefung und/oder Öffnung dazu dienen, den Verformungswiderstand des Verformungsbereichs einzustellen beziehungsweise zu beeinflussen. Dies kann beispielweise dadurch erfolgen, dass die Vertiefung und/oder Öffnung eine Vergrößerung der Oberfläche des Verformungsbereichs bewirkt beziehungsweise das von der Verformung beeinflusste Volumen der an den Verformungsbereich angrenzenden Bereiche des Verformungselements reduziert.

Dadurch steht der Verformungsbereich im Bereich der Vertiefung und/oder Öffnung nicht (Verformungsbereich weist eine Oberfläche auf, die die Vertiefung und/oder Öffnung zumindest teilweise begrenzt) beziehungsweise in verringertem Umfang in Verbindung mit einem Feststoff, inklusive insbesondere hochviskosen Flüssigkeiten wie zum Beispiel Glas. Dadurch können die mit den strukturellen Materialverlagerungen, die bei der plastischen beziehungsweise viskosen Verformung des Verformungsbereichs beim Erwärmen und Verformen stattfinden, einhergehenden Kräfte nicht beziehungsweise in geringerem Maße von dem Vakuum oder dem Material (zum Beispiel ein Gas, eine Flüssigkeit, Bereiche des Verformungselements), welches an den Verformungsbereich angrenzt, aufgenommen werden. Dies führt zu einer Verringerung des Volumens beziehungsweise der Fläche, auf das/die sich die Verformungskraft verteilen kann, und damit zu einer Reduktion des Verformungswiderstands.

Unter Verformungswiderstand wird im Rahmen der Erfindung der Widerstand verstanden, der der Verformungsbereich der Kraft, die die Verformung bedingt, also der Verformungskraft (zum Beispiel Eigengewichtskraft und/oder von außen eingebrachte Kraft), entgegensetzt. Der Verformungswiderstand resultiert aus dem Verhältnis von Verformungskraft zu der durch sie bedingten Deformationsgeschwindigkeit und verhält sich proportional zur Viskosität, insbesondere der dynamischen Viskosität, und zur Fläche beziehungsweise zu einer gedachten Schnittfläche durch den Verformungsbereich, in der die Verformungskraft wirkt.

In einer weiteren Ausführungsform erfolgt das Inkontaktbringen des Trägers mit dem Verformungselement und/oder das Aufbringen des Funktionselements auf dem Verformungselement derart, dass durch die Vertiefung und/oder Öffnung ein Hohlraum zwischen dem Verformungselement und dem Träger, zwischen dem Verformungselement und dem Funktionselement und/oder zwischen dem Funktionselement, dem Verformungselement und dem Träger gebildet wird, wobei der Hohlraum insbesondere hermetisch abgeschlossen ist.

Neben der Gewährleistung eines Abstandes zwischen verschiedenen den Hohlraum begrenzenden Oberflächenbereichen zur Vermeidung eines Kontaktes beziehungsweise eines Anhaftens der Oberflächenbereiche, insbesondere vor dem Erwärmen und Verformen, und/oder der Bereitstellung eines zumindest teilweise abgeschlossenen Volumens für die Anwendung, bei der die optische Komponente eingesetzt wird, kann in dem Hohlraum, insbesondere vor und/oder während des Erwärmen und Verformens, ein Druck unterhalb oder oberhalb des Umgebungsdrucks, insbesondere des atmosphärischen Luftdrucks, erzeugt werden. Durch eine solche Druckdifferenz zwischen dem Druck im Hohlraum und dem Umgebungsdruck kann eine Kraftwirkung zur Gewährleistung beziehungsweise Begünstigung des Verformungsprozesses erzeugt werden.

Im Falle, dass beim Verfahrensschritt des Erwärmen und Verformens der Umgebungsdruck beziehungsweise Prozessdruck dem atmosphärischen Luftdruck entspricht, wird im Hohlraum beispielsweise ein Druck zwischen etwa 15 mbar und etwa 30 mbar (Unterdruck) oder zwischen etwa 1200 mbar und etwa 1600 mbar (Überdruck) eingestellt.

Durch den Einsatz geeigneter Verbindungstechniken, wie zum Beispiel dem Bonden, lässt sich insbesondere ein von der Umgebung hermetisch dicht abschießender Hohlraum erzeugen. Indem der Verbindungsprozess bei einem bestimmten Druck durchgeführt wird, kann dieser Druckwert in dem Hohlraum erzeugt beziehungsweise eingestellt werden. Bevorzugt liegt der Druck während des Verbindungsprozesses, zum Beispiel dem anodischen Bonden bei einer Temperatur von 400°C, zwischen etwa 10 mbar und etwa 20 mbar oder zwischen etwa 800 mbar und etwa 1000 mbar. Da der anschließende Erwärmungsprozess typischerweise bei wesentlich höheren Temperaturen als der Verbindungsprozess erfolgt - das Verformungselement wird während des Verfahrensschritts des Erwärmen und Verformens beispielsweise auf eine Temperatur zwischen etwa 700 °C und etwa 900 °C gebracht - resultieren aus den angegebenen Druckbereichen im Hohlraum Drücke von etwa 15 mbar bis etwa 30 mbar beziehungsweise etwa 1200 mbar bis etwa 1600 mbar.

Da der Hohlraum in diesem Fall hermetisch dicht von der Umgebung abgeschlossen ist, bleibt der eingestellte Druckwert ohne weitere Energiezufuhr, zum Beispiel zum Betrieb einer Vakuumpumpe beziehungsweise Pumpe, über einen längeren Zeitraum und damit insbesondere für die Verformung beziehungsweise den Formgebungsprozess erhalten.

Insbesondere durch den Hohlraum zwischen dem Verformungselement und dem Träger, in dem ein Druck eingestellt wird, der während des Erwärmens zu einem Über- oder Unterdruck in Relation zum Umgebungsdruck beziehungsweise Prozessdruck führt, kann eine Kraftwirkung auf das Verformungselement erreicht werden, wodurch zumindest ein Bereich des Verformungselements beziehungsweise des Verformungsbereichs verformt und dadurch das Funktionselemente ausgelenkt wird. In diesem Fall wird das Funktionselement lediglich in dem Bereich mit einer Kraftwirkung beaufschlagt, der mit dem Verformungsbereich beziehungsweise dem Verformungselement während des Verformungsprozesses in Kontakt beziehungsweise in Verbindung steht. Andere Bereiche des Funktionselements, zum Beispiel den Hohlraum zwischen Träger, Verformungselement und Funktionselement begrenzende Oberflächenbereiche, sind keiner die Verformung des Verformungsbereichs bedingenden Kraftwirkung ausgesetzt, so dass die mechanische Belastung dieser Bereiche reduziert wird und ihre Form beziehungsweise Oberflächenqualität (zum Beispiel Ebenheit und Planparallelität) besonders gut erhalten werden kann.

Durch das Inkontaktbringen des Verformungselements mit dem Träger wird die erste Kontaktfläche beziehungsweise Grenzfläche zwischen dem Verformungselement und dem Träger gebildet und durch das Aufbringen des Funktionselements auf dem Verformungselement wird die zweite Kontaktfläche beziehungsweise Grenzfläche zwischen dem Funktionselement und dem Verformungselement gebildet, wobei die zweite Kontaktfläche die erste Kontaktfläche zumindest teilweise überlappt. Der Bereich des Verformungselements, der zwischen den sich überlappenden Bereichen der beiden Kontaktflächen ausgebildet ist, bildet den Verformungsbereich.

Die sich überlappenden Bereiche der beiden Kontaktflächen (Überlappungsbereiche) umfassen insbesondere die Bereiche der ersten und zweiten Kontaktfläche, deren Punkte mit mindestens einem ihrer auf die jeweils andere Kontaktfläche projizierten Abbildern, die bei Erfüllung der nachfolgenden Kriterien wie die Punkte selbst ebenfalls zu den Überlappungsbereichen gehören, durch jeweils eine Verbindungslinie verbunden werden können, welche über die volle Länge durch das Verformungselement beziehungsweise durch das Verformungselement und einem damit in Kontakt stehenden Festkörper (zum Beispiel Einschlüsse) und entsprechend nicht durch eine Vertiefung, Öffnung beziehungsweise Loch oder einen Hohlraum, der zum Beispiel Vakuum, ein Gas oder eine Flüssigkeit umfasst, verläuft. Ein Punkt und sein Abbild, deren Verbindungslinie die obigen Kriterien erfüllt, werden im Weiteren als Punkt/Abbild-Paar bezeichnet.

Die Projektion eines Punktes einer Kontaktfläche auf die andere Kontaktfläche erfolgt insbesondere derart, dass die Verbindungslinie zwischen dem Punkt und seinem Abbild auf der anderen Kontaktfläche die kürzeste Verbindung beziehungsweise den kürzesten Abstand zwischen dem Punkt und dem Abbild beschreibt (im Weiteren als "Minimalprojektion" bezeichnet) und/oder dass der Punkt mittels Orthogonalprojektion auf die andere Kontaktfläche abgebildet wird.

Sollten zu einem Punkt insbesondere beide Projektionen (Minimalprojektion und Orthogonalprojektion) zu Abbildern führen beziehungsweise mehrere Abbilder existieren und ein Punkt mehrere Punkt/Abbild-Paare bedingen, so gehören neben dem Punkt auch alle seine Abbilder der Punkt/Abbild-Paare zu den Überlappungsbereichen. Sind einem Punkt beispielsweise zwei Abbilder zuzuordnen, existieren entsprechend die Punkt/Abbild-Paare Punkt/Abbild1 und Punkt/Abbild2, so gehören der Punkt sowie Abbild1 und Abbild2 zu den Überlappungsbereichen.

Ausgenommen sind insbesondere Punkt/Abbild-Paare, bei denen die Minimalprojektion des Punktes ein Abbild auf dem Rand der anderen Kontaktfläche erzeugt. Die Punkte und Abbilder solcher Punkt/Abbild-Paare gehören nicht zu den Überlappungsbereichen. Existieren beispielsweise wiederum Punkt/Abbild1 und Punkt/Abbild2, wobei Abbild2 eine Minimalprojektion des Punktes auf den Rand der anderen Kontaktfläche ist, so gehören nur der Punkt und Abbild1 (gemäß Punkt/Abbild-Paar Punkt/Abbild1) zu den Überlappungsbereichen.

In einer weiteren Ausführungsform gehören Kontaktflächen, die nur Punkte umfassen, deren Minimalprojektion zu Abbildern führen, die auf den Rand der anderen Kontaktfläche fallen, unabhängig vom Ergebnis der Orthogonalprojektion nicht zu den Überlappungsbereichen.

Der Verformungsbereich erstreckt sich im Rahmen der Erfindung insbesondere auf den Bereich des Verformungselements, der durch die Überlappungsbereiche begrenzt und durch die Verbindungslinien der Punkt/Abbild-Paare, die zu den Überlappungsbereichen gehören, durchlaufen wird.

Gemäß den Ausführungsformen des Standes der Technik weist das zu verformende Substrat unterschiedliche Bereiche auf, die verschiedene Funktionen übernehmen, wie zum Beispiel den auszulenkenden funktionellen Bereich, der im Rahmen der Anwendung der optischen Komponente üblicherweise eine optische Funktion (zum Beispiel die eines Fensters) zu erfüllen hat, den Auflagebereich, der von einem Träger unterstützt wird und so eine Relativbewegung zwischen dem Auflagebereich und dem funktionellen Bereich des zu verformenden Substrats ermöglicht, und dem Verformungsbereich, durch dessen Formänderung ein Auslenken des funktionellen Bereichs gewährleistet wird. Da diese Bereiche gemäß dem Stand der Technik lateral benachbart angeordnet sind, sind zu verformende Substrate mit entsprechenden lateralen Abmessungen erforderlich.

Durch die erfindungsgemäße Anordnung des Verformungsbereichs zwischen dem Funktionselement und dem Träger können mehrere, insbesondere alle, Funktionalitäten der genannten Bereiche im Verformungsbereich konzentriert beziehungsweise zusammengeführt werden, wodurch eine signifikante Einsparung von Material und damit geringere Kosten verbunden sind, da Verformungselemente mit geringeren lateralen Abmessungen erforderlich sind beziehungsweise mehr optische Komponenten pro lateraler Ausdehnung des Verformungselements hergestellt werden können.

In einer weiteren Ausführungsform sind die erste und/oder zweite Kontaktfläche beziehungsweise die sich überlappenden Bereiche der ersten und/oder zweiten Kontaktfläche und/oder der Verformungsbereich in Form eines Rahmens beziehungsweise rahmenförmig (zum Beispiel eine Kontaktfläche in Form eines Kreisrings), insbesondere um die Vertiefung und/oder Öffnung im Verformungselement beziehungsweise die Vertiefung und/oder Öffnung umschließend und bevorzugt geschlossen, ausgebildet. Die solche rahmenförmigen, insbesondere geschlossenen, Überlappungsbereiche bedingenden Bereiche des Verformungselements können im Weiteren als Verbindungsflächen dienen, um zum Beispiel die durch den rahmenförmigen Verformungsbereich umschlossene Vertiefung und/oder Öffnung durch eine Verbindung des Verformungselements mit einem oder mehreren Verkapselungselementen, insbesondere hermetisch, abzuschließen. Dadurch lassen sich zum Beispiel MEMS oder MOEMS mit der geforderten Bewegungsfreiheit verkapseln. Eine weitere räumliche beziehungsweise materielle Optimierung, die zur Reduktion der Herstellungskosten beitragen kann, lässt sich dadurch erreichen, dass der Verformungsbereich, insbesondere der rahmenförmige Verformungsbereich, zumindest teilweise die Vertiefung und/oder Öffnung im Verformungselement beziehungsweise den Hohlraum, insbesondere zwischen dem Verformungselement und dem Träger und/oder zwischen dem Funktionselement, dem Verformungselement und dem Träger, begrenzt. Dies führt zudem dazu, dass der Verformungsbereich eine Oberfläche aufweist, die wie beschrieben einen Einfluss auf den Verformungswiderstand hat.

Die Größe des Verformungswiderstands des Verformungsbereichs wird beispielsweise durch das verwendete Material, die Gestalt beziehungsweise Form und die Anordnung des Verformungsbereichs, zum Beispiel ob der Verformungsbereich an ein Gas oder einen Feststoff angrenzt, bestimmt. So können durch geometrische Asymmetrien des Verformungsbereichs Asymmetrien des Verformungswiderstandes (Widerstandsasymmetrie) erreicht werden, die mechanische Spannungsverteilungen im Verformungsbereich bedingen können, welche zu lokal unterschiedlichen Deformationsgeschwindigkeiten führen. Dadurch kann ein verformungsbedingtes Neigen des Funktionselements unterstützt beziehungsweise erreicht werden.

In einer bevorzugten Ausführungsform weisen mindestens zwei Segmente des rahmenförmigen Verformungsbereichs (Rahmensegmente), insbesondere während des Erwärmen und Verformens, unterschiedlich große Verformungswiderstände auf, wodurch insbesondere ein Neigen des Funktionselements beim Verfahrensschritt des Erwärmen und Verformens begünstigt beziehungsweise unterstützt werden kann.

In einer weiteren Ausführungsform sind zwei oder mehrere Verformungsbereiche ausgebildet, die mit demselben Funktionselement in Kontakt stehen beziehungsweise durch dasselbe Funktionselement begründet werden und bevorzugt diametral um die Vertiefung und/oder Öffnung im Verformungselement ausgebildet sind und/oder die Vertiefung und/oder Öffnung im Verformungselement zumindest teilweise begrenzen. Die dadurch erreichte räumliche beziehungsweise materielle Optimierung kann zur Senkung der Herstellungskosten beitragen.

Bevorzugt weisen die zwei Verformungsbereiche beziehungsweise jeweils ein Teilbereich der zwei Verformungsbereiche (zwei Verformungsteilbereiche), insbesondere während des Erwärmen und Verformens, unterschiedlich große Verformungswiderstände auf, wodurch ein Neigen des Funktionselements beim Verfahrensschritt des Erwärmen und Verformens begünstigt beziehungsweise unterstützt werden kann.

Die zwei Verformungsbereiche können Bereiche desselben Verformungselements sein und durch mindestens einen Bereich dieses Verformungselements, der nicht als Verformungsbereich fungiert, getrennt sein oder die zwei Verformungsbereiche können unterschiedlichen Verformungselementen zuzuordnen sein.

Der Einsatz mehrerer Verformungsbereiche in Verbindung mit einem Funktionselement, insbesondere die Verwendung mehrerer Verformungselemente, ermöglicht eine Flexibilisierung des Verfahrens, da die Verformungsbereiche beziehungsweise die Verformungselemente individuell gestaltet werden können. So können die zwei Verformungsbereiche unterschiedlich große Verformungswiderstände aufweisen, indem beispielsweise verschiedene Materialien verwendet und/oder die zwei Verformungsbereiche geometrisch unterschiedlich gestaltet werden, um ein Neigen des Funktionselements beim Verfahrensschritt des Erwärmen und Verformens (beim Erwärmen und Verformen) zu begünstigen beziehungsweise zu unterstützen.

Die strukturellen beziehungsweise geometrischen Betrachtungen in Bezug auf den Verformungsbereich beziehen sich im Rahmen der Erfindung insbesondere auf die Form des Verformungsbereichs vor der Formgebung des Verformungselements beziehungsweise vor dem Verfahrensschritt des Verformens des Verformungsbereichs.

Durch eine spezifische Gestaltung des Verformungsbereichs kann die Art der Auslenkung des Funktionselements gezielt beeinflusst und insbesondere ein Neigen des Funktionselements begünstigt beziehungsweise unterstützt werden.

Daher sind in einer weiteren Ausführungsform der rahmenförmige Verformungsbereich oder die zwei Verformungsbereiche derart ausgebildet, dass die Flächeninhalte von zwei Querschnittsflächen des rahmenförmigen Verformungsbereichs und/oder die Flächeninhalte von zwei Querschnittsflächen und/oder von zwei Gesamtquerschnittsflächen der zwei Verformungsbereiche, wobei die Querschnittsflächen nicht demselben Verformungsbereich der zwei Verformungsbereiche zuzuordnen sind, unterschiedlich groß sind.

Der im Weiteren verwendete Begriff der Rahmenoberfläche bezeichnet die Oberfläche des rahmenförmigen Verformungsbereichs nach Abstraktion durch Freistellung des Verformungsbereichs. Dabei ist unter Freistellung die gedachte Entfernung aller Elemente und Bereiche, die nicht zum rahmenförmigen Verformungsbereich gehören, zu verstehen. Entsprechend setzt sich die Rahmenoberfläche aus realen Oberflächen (Oberflächen) und/oder aus durch die Abstraktion resultierenden Oberflächen, die durch Freistellung aus realen Grenzflächen (insbesondere zwischen dem Verformungsbereich und dem Träger oder dem Funktionselement) und/oder gedachten Grenzflächen (insbesondere zwischen dem Verformungsbereich und einem daran angrenzenden Bereich des Verformungselements, der nicht zum Verformungsbereiche gehört) entstehen, zusammen.

Eine Querschnittfläche des rahmenförmigen Verformungsbereichs umfasst insbesondere die Menge aller Punkte des rahmenförmigen Verformungsbereichs, die durch eine ebene geschlossene Kurve begrenzt wird, wobei die Kurve ausgehend von einem Punkt der Rahmenoberfläche die kürzeste auf der Rahmenoberfläche verlaufende Verbindung zu dem Punkt selbst beschreibt (entsprechend beginnt und endet die Kurve in demselben Punkt), so dass die Kurve nur Punkte einschließt, die zum rahmenförmigen Verformungsbereich aber nicht zur Rahmenoberfläche gehören. Entsprechend sind die Punkte der Kurve die einzigen Punkte der Rahmenoberfläche, die von der Querschnittsfläche mit umfasst sind.

Und/Oder die zu vergleichenden Querschnittsflächen des rahmenförmigen Verformungsbereichs resultieren insbesondere aus einem Schnitt des rahmenförmigen Verformungsbereichs durch eine Schnittebene, die durch zwei orthogonal zueinander liegende Hauptträgheitsachsen und/oder Hauptvolumenachsen (Hauptträgheitsachsen bei Fiktion einer homogenen Masseverteilung) des rahmenförmigen Verformungsbereichs aufgespannt wird, wobei nur die Schnittebenen Berücksichtigung finden, die im Ergebnis des Schnitts zwei Querschnittsflächen zur Folge haben und die beiden Kontaktflächen schneiden.

Die zu vergleichenden Querschnittsflächen der zwei Verformungsbereiche resultieren insbesondere aus einem Schnitt durch beide Verformungsbereiche durch eine Schnittebene, auf der beide Volumenschwerpunkte der beiden Verformungsbereiche liegen und die derart ausgerichtet ist, dass die beiden Kontaktflächen geschnitten werden und die Summe der Flächeninhalte der beiden Querschnittsflächen ein Minimum ergibt. Sollte der Schnitt für einen Verformungsbereich mehrere Schnittflächen zur Folge haben, so werden deren Flächeninhalte addiert, um den Flächeninhalt einer resultierenden Querschnittfläche zu erhalten, die für den Vergleich herangezogen werden kann.

Eine Gesamtquerschnittfläche ist die Summe der Querschnittflächen der zwei Verformungsbereiche, wobei die Querschnittsflächen durch einen Schnitt der zwei Verformungsbereiche durch die vorhergehend (oben) definierte Schnittebene oder durch eines ihrer durch Parallelverschiebung der Schnittebene in Richtung ihrer Normalenvektoren generierten Abbilder gebildet werden.

Durch ein Verschieben der Schnittebene beziehungsweise Ebene, in der die Querschnittsfläche liegt, in die durch die Normalenvektoren dieser Ebene vorgegebenen Richtungen um infinitesimale Strecken gleicher Länge wird insbesondere ein infinitesimales Volumenelement und damit ein Segment des rahmenförmigen Verformungsbereichs (Rahmensegment) oder ein Teilbereich eines Verformungsbereichs (Verformungsteilbereich) definiert, wobei beim Vergleich zweier Volumenelemente beide Volumenelemente durch infinitesimale Strecken gleicher Länge aufgespannt werden.

In einer weiteren Ausführungsform weist der Verformungsbereich eine Oberfläche auf, wobei insbesondere die zwei Segmente des rahmenförmigen Verformungsbereichs und/oder die zwei Verformungsbereiche und/oder die zwei Verformungsteilbereiche Oberflächen mit unterschiedlich großem Flächeninhalt aufweisen.

Die Oberfläche des Verformungsbereichs kann durch Strukturierung des Verformungselements, insbesondere durch Sägen und/oder Ätzen, erzeugt beziehungsweise vergrößert werden. Dadurch kann der Verformungswiderstand beeinflusst beziehungsweise eingestellt, insbesondere verkleinert, werden.

So kann der Unterschied in der Größe der Flächeninhalte der Oberflächen der zwei Segmente des rahmenförmigen Verformungsbereichs und/oder der zwei Verformungsbereiche und/oder der zwei Verformungsteilbereiche durch unterschiedlich tiefe Sägeschnitte in das Verformungselement erreicht werden.

Gemäß einer weiteren Ausführungsform erfolgt die Strukturierung des Funktionselements und die Strukturierung des Verformungselements, insbesondere zur Vergrößerung der Oberfläche des Verformungsbereichs, in demselben Prozessschritt, insbesondere einem Sägeschritt. Dadurch können Prozessschritte eingespart und das Verfahren vereinfacht werden.

Bei einer weiteren Ausgestaltung der Erfindung sind die Flächeninhalte der jeweiligen Bereiche der ersten und/oder zweiten Kontaktfläche, die die zwei Segmente des rahmenförmigen Verformungsbereichs und/oder die zwei Verformungsbereiche beziehungsweise die zwei Verformungsteilbereiche begrenzen beziehungsweise daran angrenzen, unterschiedlich groß, wodurch lokal unterschiedliche Verformungswiderstände bedingt werden können, um ein Neigen des Funktionselements zu erreichen beziehungsweise zu begünstigen.

In einer weiteren Ausführungsform beschreibt der äußere Rand der ersten und/oder zweiten rahmenförmigen Kontaktfläche, insbesondere des rahmenförmigen sich überlappenden Bereichs der ersten und/oder zweiten Kontaktfläche, eine erste geometrische Figur und der innere Rand eine zweite geometrische Figur, wobei die erste und die zweite geometrische Figur unabhängig voneinander jeweils ausgewählt sind aus der Gruppe bestehend aus Rechteck, Trapez, insbesondere gleichschenkliges oder rechtwinkliges Trapez, Kreis und Dreieck.

Durch die Kombination entsprechender Geometrien für den äußeren und inneren Rand können unterschiedlich ausgebildete Kontaktflächen beziehungsweise sich überlappende Bereiche der Kontaktflächen und damit unterschiedlich gestaltete Verformungsbereiche erzeugt werden, wodurch lokal unterschiedliche Verformungswiderstände eingestellt werden können.

So wird in einer beispielhaften Ausführungsform der äußere und der innere Rand des rahmenförmigen sich überlappenden Bereichs der ersten und/oder zweiten Kontaktfläche jeweils durch ein Rechteck beschrieben, deren Umkreismittelpunkte nicht zusammenfallen, wobei insbesondere eine Symmetrieachse des den inneren Rand beschreibenden Rechtecks und eine Symmetrieachse des den äußeren Rand beschreibenden Rechtecks auf derselben Gerade liegen. Dadurch weisen zwei sich gegenüberliegende Schenkel des jeweiligen rahmenförmigen Überlappungsbereichs identische Flächeninhalte auf und die anderen beiden sich gegenüberliegenden Schenkel weisen unterschiedliche Flächeninhalte auf, wodurch der Verformungsbereich beziehungsweise dessen Verformungswiderstand asymmetrisch eingestellt werden kann.

In einer weiteren Ausführungsform wird ein Bereich des Verformungselements mit einer Stabilisierungsschicht versehen, die der Verformung des Verformungselements beziehungsweise des Verformungsbereichs, insbesondere lokal, entgegenwirkt. Insbesondere grenzt die Stabilisierungsschicht an den Verformungsbereich an beziehungsweise bedeckt zumindest einen Teil der Oberfläche des Verformungsbereichs. Vorzugsweise kann die Stabilisierungsschicht an einen der zwei Segmente des rahmenförmigen Verformungsbereichs und/oder an einen der zwei Verformungsbereiche beziehungsweise Verformungsteilbereiche angrenzen und/oder zumindest einen Teil der Oberfläche eines der zwei Segmente des rahmenförmigen Verformungsbereichs und/oder eines der zwei Verformungsbereiche beziehungsweise Verformungsteilbereiche bedecken.

Dadurch können Bereiche des Verformungselements beziehungsweise des Verformungsbereichs verstärkt beziehungsweise stabilisiert werden, um einer Verformung dieser Bereiche entgegenzuwirken. In Verbindung mit Bereichen des Verformungselements, die nicht mit einer Stabilisierungsschicht versehen sind, kann dadurch ein Neigen des Funktionselements begünstigt beziehungsweise unterstützt werden.

Bei der Formgebung des Verformungselements beziehungsweise bei der Verformung des Verformungsbereichs beim Verfahrensschritt des Erwärmen und Verformens werden insbesondere die Fließeigenschaften des Verformungsbereichs beziehungsweise des Materials des Verformungsbereichs, wie sie insbesondere in der Nähe und oberhalb der Erweichungstemperatur (softening point) oder der Solidustemperatur vorliegen, ausgenutzt. Der Vorteil dieser Art der Formgebung, insbesondere auch als Glasfließen bezeichnet, gegenüber anderen Formgebungs- oder Prägeverfahren, wie Glastiefziehen oder Glasprägen (zum Beispiel Blankpressen), besteht vor allem darin, dass sich insbesondere optische Komponenten mit Substrat- beziehungsweise Waferausdehnungen, insbesondere Substrat- beziehungsweise Waferdurchmessern größer gleich 80 mm, bevorzugt größer gleich 150mm, besonders bevorzugt größer gleich 300mm, mit hoher Oberflächenqualität, insbesondere geringer Oberflächenrauigkeit, hoher Oberflächenebenheit und hoher Planparallelität der Oberflächen der Substratseiten, realisieren lassen.

Insbesondere wenn das Ausgangssubstrat aus Glas besteht, ist häufig die Oberflächenrauigkeit der optischen Komponenten, die beispielsweise mittels Glastiefziehen oder Glasprägen hergestellt wurden, nicht zufriedenstellend. Die mittels Glasziehen geformten Substrate sind aufgeraut und können die Anforderungen beispielsweise an ein optisches Fenster nicht erfüllen.

Beim Blankpressen sind die maximalen Ausdehnungen beziehungsweise Abmessungen der herstellbaren optischen Komponenten stark limitiert. Des Weiteren sind bei diesem Prägeverfahren sehr hochwertige, beständige und damit teure Prägewerkzeuge erforderlich, was eine flexible Fertigung einschränkt.

Beim Verfahrensschritt des Erwärmen und Verformens wird zumindest ein Teil des Verformungsbereichs derart erwärmt und verformt, dass das Funktionselement zumindest teilweise beziehungsweise bereichsweise ausgelenkt wird, sich insbesondere verschiebt, neigt und/oder verdreht (Torsion).

Sollte das Verformungselement beziehungsweise der Verformungsbereich insbesondere auch im Bereich der ersten und/oder zweiten Kontaktfläche erwärmt werden, so kann ein qualitativ hochwertiger Oberflächenbereich des Funktionselements und/oder des Trägers mit beispielsweise geringer Rauigkeit und Ebenheitsabweichung durch den Kontakt zum Verformungselement auf die Oberfläche des Verformungselements abgeformt werden. Dies hat den Vorteil, dass die Anforderungen an die Oberflächenqualität des bereitgestellten Verformungselements in dem entsprechenden Bereich geringer sein können und ein eventuell notwendiger Bearbeitungsschritt, wie zum Beispiel das Polieren, entfallen kann.

Um eine solche Abformung zu ermöglichen beziehungsweise um insbesondere die Form des Funktionselements und seine Oberflächeneigenschaften zu erhalten, ist insbesondere die obere Kühltemperatur oder die Solidustemperatur des Materials des Funktionselements und/oder des Trägers größer als die obere Kühltemperatur oder die Solidustemperatur des Materials des Verformungselements beziehungsweise des Verformungsbereichs, wobei die Temperaturdifferenz zwischen der jeweiligen oberen Kühltemperatur beziehungsweise Solidustemperatur des Materials des Funktionselements und/oder des Trägers und des Materials des Verformungselements beziehungsweise des Verformungsbereichs möglichst groß sein sollte, insbesondere größer gleich 100K. Besteht das Funktionselement und/oder der Träger beispielsweise aus Silizium und der Verformungsbereich aus Borsilikatglas, so ist für die Differenzbildung die Solidustemperatur beziehungsweise Schmelztemperatur von Silizium und die obere Kühltemperatur von Borsilikatglas maßgebend.

In einer vorteilhaften Ausführungsform liegt die Erweichungstemperatur oder Liquidustemperatur des Materials des Verformungselements beziehungsweise des Verformungsbereichs unterhalb der Erweichungstemperatur oder Liquidustemperatur, insbesondere unterhalb der oberen Kühltemperatur oder Solidustemperatur, des Materials des Funktionselements und/oder des Trägers. Dadurch kann ein effizienter Verformungsprozess bei gleichzeitiger Erhaltung der Form des Funktionselements und/oder des Trägers bedingt werden.

Entsprechend wird beim Verfahrensschritt des Erwärmen und Verformens zumindest ein Teil des Verformungsbereichs, insbesondere der gesamte Verformungsbereich beziehungsweise das Verformungselement, bevorzugt auf eine Temperatur gebracht, die oberhalb der oberen Kühltemperatur oder Solidustemperatur des Materials des Verformungsbereichs beziehungsweise des Verformungselements und unterhalb der oberen Kühltemperatur oder Solidustemperatur des Materials des Funktionselements und/oder des Trägers liegt.

Das Temperaturintervall zwischen Solidus- und Liquidustemperatur eines Materials beziehungsweise Stoffes wird als Schmelzintervall oder Schmelzbereich bezeichnet. Bei zum Beispiel eutektischen Legierungen und reinen Metallen fallen die Solidus- und die Liquidustemperatur zusammen. In diesen Fällen haben Solidus- und Liquidustemperatur denselben Wert, der als Schmelzpunkt bezeichnet wird.

Insbesondere wird zumindest ein Teil des Verformungsbereichs, insbesondere der gesamte Verformungsbereich beziehungsweise das Verformungselement, beim Verfahrensschritt des Erwärmen und Verformens auf eine Temperatur gebracht, die zwischen der Erweichungstemperatur minus 150°C und der Erweichungstemperatur plus 100°C des Materials des Verformungsbereichs beziehungsweise des Verformungselements liegt.

Insbesondere in Bezug auf die Verwendung von Gläsern beziehungsweise glasähnlichen Materialien für den Verformungsbereich beziehungsweise das Verformungselement sind die obere Kühltemperatur und die Erweichungstemperatur wichtige Eigenschaften zur Beurteilung der Eignung für den Verformungsprozess.

Unterhalb der oberen Kühltemperatur ist die Viskosität zum Beispiel eines Glases und damit sein Verformungswiderstand üblicherweise zu hoch für die Durchführung eines praktikablen Verformungsprozesses. Oberhalb der oberen Kühltemperatur wird die Viskosität geringer und die Verformungseigenschaften verbessern sich. Im Bereich der Erweichungstemperatur weist das entsprechende Material besonders günstige Verformungseigenschaften, insbesondere bezüglich Viskosität, auf.

Bei Verwendung von Borsilikatglas, mit einer Erweichungstemperatur von etwa 820 °C, sind beim Verfahrensschritt des Erwärmen und Verformens beispielsweise Temperaturen zwischen etwa 700 °C und etwa 900 °C zweckmäßig.

Für jedes Glas lässt sich ein Kühlbereich festlegen, welcher von der oberen und unteren Kühltemperatur begrenzt wird. Die Lage dieser Temperaturen definiert sich nach der Viskosität, wobei die obere Kühltemperatur die Temperatur ist, bei der das Glas eine Viskosität von 10¹³ beziehungsweise 10^{13,3} dPa·s besitzt. Bei der unteren Kühltemperatur beträgt die Viskosität 10^{14,5} dPa·s.

Die Bestimmungsmethode zur Ermittlung der oberen Kühltemperatur ist eine direkte Viskositätsbestimmung, die als Fadenziehmethode mit der nachfolgend beschriebenen Methode von Littleton verwandt ist, nur das die Temperatur aufgesucht wird, bei der unter einer Belastung von 1000 g der Faden sich mit einer Geschwindigkeit von 0,136 mm/min verlängert. Dann beträgt die Viskosität 10¹³ beziehungsweise 10^{13,3} dPa·s. Kühlt man den Ofen weiter ab, erhält man durch Extrapolation auf die Verlängerungsgeschwindigkeit von 0,0043 mm/min den Wert für die untere Kühltemperatur.

Die Erweichungstemperatur oder der Erweichungspunkt (softening point), auch Littletontemperatur oder Littleton-Punkt genannt, wird nach einer Methode von Littleton bestimmt. Dabei wird ein Materialfaden (zum Beispiel ein Glasfaden) mit einem Durchmesser von 0,65 mm bis 1,0 mm und einer Länge von 22,9 cm in einen Ofen bestimmter Konstruktion gehängt. Bei einer Aufheizgeschwindigkeit von 5 bis 10 K/min beobachtet man das aus dem Ofen heraushängende untere Ende des Fadens. Mit steigender Temperatur verlängert sich der Faden unter dem eigenen Gewicht. Die Temperatur, bei der die Verlängerung 1 mm/min beträgt, wird als Littletontempertur bezeichnet. Die meisten Gläser oder glasähnlichen Materialien weisen bei dieser Temperatur eine Viskosität von etwa 10^{7,6} dPa·s auf (Scholze, Horst "Glas - Natur, Struktur und Eigenschaften", 3. Auflage, Springer Verlag, S. 151).

Bevorzugt bleibt während des Erwärmen und Verformens zumindest ein Teil des überlappenden Bereichs der ersten Kontaktfläche und zumindest ein Teil des überlappenden Bereichs der zweiten Kontaktfläche erhalten beziehungsweise bestehen, wobei der überlappende Bereich der ersten Kontaktfläche und der überlappende Bereich der zweiten Kontaktfläche insbesondere denselben Verformungsbereich begrenzen. Dementsprechend wird der Kontakt zwischen dem Verformungselement und dem Träger im Überlappungsbereich und der Kontakt zwischen dem Funktionselement und dem Verformungselement im Überlappungsbereich während des Erwärmen und Verformens zumindest teilweise nicht gelöst, um während des Erwärmen und Verformens eine effektive Kraftübertragung auf den Verformungsbereich zu gewährleisten und/oder ein oder mehrere Oberflächenbereiche des Funktionselements und/oder des Trägers auf das Verformungselement abzuformen.

Besonders bevorzugt bleiben die Überlappungsbereiche während des Erwärmen und Verformens vollständig beziehungsweise komplett erhalten beziehungsweise bestehen.

Der Verfahrensschritt des Erwärmen und Verformens wird bevorzugt zeitgesteuert oder bis zum Kontakt des Verformungselements und/oder des Funktionselements mit einer Auslenkungsbegrenzung, die beispielsweise die maximal gewünschte verformungsgedingte Auslenkung begrenzt, durchgeführt. Als Auslenkungsbegrenzung kann zum Beispiel ein Werkzeug, ein Funktionselement und/oder der Träger, insbesondere die Bodenfläche der Vertiefung im Träger, dienen. Dadurch kann die Genauigkeit der Auslenkung erhöht beziehungsweise die Reproduzierbarkeit der optischen Komponente verbessert werden.

Beim Verfahrensschritt des Erwärmen und Verformens wird zumindest ein Teil des Verformungsbereichs durch eine Kraft (Verformungskraft) verformt, wobei sich die Verformung über den Verformungsbereich hinaus auf Bereiche des Verformungselements, die nicht zum Verformungsbereich gehören, erstrecken können. Insbesondere an den Verformungsbereich angrenzende Bereiche können auf Grund der materiellen Kopplung zum Verformungsbereich durch den Verformungsprozess mit verformt werden, da sich die durch die Verformungskraft gedingten Spannungsbeziehungsweise Geschwindigkeitsverläufe im Verformungselement über den Verformungsbereich hinaus erstrecken können.

Die Verformung des Verformungsbereichs kann bevorzugt durch die Eigengewichtskraft des Funktionselements und/oder des Verformungsbereichs beziehungsweise des Verformungselements und/oder durch eine von außen eingebrachte Kraft bedingt werden.

Eine von außen eingebrachte Kraft beziehungsweise Verformungskraft kann zweckmäßigerweise auf einer mechanischen, zum Beispiel einer pneumatischen, und/oder magnetischen und/oder elektrischen und/oder piezoelektrischen Wechselwirkung beruhen.

In einer weiteren Ausführungsform wird, wie vorher beschrieben, die von außen eingebrachte Kraft durch eine Druckdifferenz zwischen zwei, sich insbesondere gegenüberliegenden Seiten des Funktionselements und/oder durch eine Druckdifferenz zwischen zwei, sich insbesondere gegenüberliegenden Seiten des Verformungselements bewirkt. Wie bei der Verformung durch die Eigengewichtskraft muss auch bei dieser Methode der Krafteinbringung das Verformungselement und/oder das Funktionselement nicht mit einem weiteren Gegenstand, beispielsweise einem Prägewerkzeug, in Kontakt gebracht werden, der die Oberflächenqualität des Verformungselements und/oder des Funktionselements mindern könnte. Entsprechend kann mit dieser Art der Krafteinbringung eine hohe Oberflächenqualität des Verformungselements und/oder des Funktionselements konserviert beziehungsweise gewährleistet werden.

Zudem kann in diesem Fall das Erwärmen und Verformen so lange durchgeführt werden, bis eine durch die Verformung des Verformungsbereichs beziehungsweise des Verformungselements bedingte Volumenänderung des Hohlraums zu einem Druck in dem Hohlraum führt, der dem Umgebungsdruck entspricht.

Auch speziell gestaltete Formgebungsvorrichtungen eignen sich für das Einbringen einer Verformungskraft, wobei das Funktionselement eine Schutzfunktion übernehmen kann, um einen Kontakt der Formgebungsvorrichtung mit dem Verformungselement, insbesondere beim Verfahrensschritt des Erwärmen und Verformens, zu vermeiden. Ein Kontakt der Formgebungsvorrichtung mit dem Verformungselement könnte zu einem Anhaften führen, was beim Ablösen der Formgebungsvorrichtung zu Defekten am Verformungselement führen könnte.

Zudem kann das Funktionselement eine durch die Formgebungsvorrichtung lokal eingebrachte Kraft in eine flächige Kraftwirkung auf den Verformungsbereich verteilen.

Neben dem Angriffspunkt der Verformungskraft sind Eigenschaften wie zum Beispiel der Verformungswiderstand des Verformungsbereichs beziehungsweise des Verformungselements in Bezug auf die angreifende Verformungskraft maßgebend dafür, wie das Funktionselement ausgelenkt wird.

Wie bereits beschrieben, kann das Funktionselement beim Aufbringen auf dem Verformungselement mit diesem in Verbindung gebracht werden. Zudem beziehungsweise alternativ ist es möglich, dass das Funktionselement beim Aufbringen auf dem Verformungselement auf dem Verformungselement angeordnet und die Verbindung zwischen dem Funktionselement und dem Verformungselement beim Verfahrensschritt des Erwärmen und Verformens, insbesondere durch thermisches Bonden, hergestellt wird.

Insbesondere wenn die Verbindung zwischen dem Funktionselement und dem Verformungselement beim Erwärmen und Verformen erzeugt wird, kann ein zusätzlicher Prozessschritt für das Verbinden eingespart werden, der eine zusätzliche insbesondere thermische Belastung insbesondere für das Funktionselement darstellen und die Qualität, insbesondere die optische Qualität, nachteilig beeinflussen könnte. Zudem kann insbesondere durch das thermische Bonden ein besonders effektives Abformen des Oberflächenbereichs beziehungsweise der Oberflächenstruktur des Funktionselements auf das Verformungselement gewährleistet werden.

Durch eine Verbindung zwischen dem Funktionselement und dem Verformungselement kann eine hohe Lagestabilität der Elemente, insbesondere ihrer Kontaktflächen, zueinander gewährleistet werden und so eine hohe Oberflächenqualität der Kontaktfläche/n konserviert und damit erhalten und/oder geschützt und/oder generiert werden. Des Weiteren kann durch die Verbindung eine effektive Kraftübertragung zur Verformung des Verformungsbereichs beziehungsweise des Verformungselements gewährleistet werden.

Durch eine Verbindung, insbesondere durch eine stoffschlüssige Verbindung, des Funktionselements mit dem Verformungselement kann auch nach dem Erwärmen und Verformen eine stabile Lage der Elemente zueinander gewährleistet werden, so dass bei Aufrechterhaltung der Verbindung eine optische Komponente hergestellt werden kann, die beide Elemente und damit beispielsweise unterschiedliche Materialien umfassen kann, oder so dass die verbundenen Elemente einem von der Formgebungsvorrichtung beziehungsweise den Vorrichtungen zur Einbringung der Verformungskraft unabhängigen Trennschritt, zum Beispiel einem selektiven Ätzschritt, zugeführt werden können. Durch eine solche Trennung von Formgebung und Trennschritt lassen sich auch Verformungselemente mit komplexen Strukturen - die insbesondere große topografische Kontraste, wie beispielsweise schmale tiefe Grabenstrukturen oder rechtwinklig zueinander ausgebildete Flächen, aufweisen - ohne Qualitätsverlust vom Funktionselement trennen.

Insbesondere wenn das mindestens eine Funktionselement keine weiteren Funktionen zu erfüllen hat, wird dieses bevorzugt in einem weiteren Verfahrensschritt zumindest teilweise, bevorzugt komplett, entfernt beziehungsweise vom Verformungselement getrennt.

Besonders bevorzugt erfolgt das Entfernen derart, dass das Funktionselement wiederverwendet und mehrfach eingesetzt werden kann, wodurch die Effizienz des Verfahrens erhöht und der Fertigungsaufwand beziehungsweise die Fertigungskosten reduziert werden können.

Dies lässt sich beispielsweise dadurch realisieren, dass das Funktionselement zumindest in dem Bereich, der mit dem Verformungselement in Verbindung gebracht wird, eine Opferschicht aufweist, die nach dem Verformen des Verformungselements zur Freigabe des Funktionselements entfernt wird. Alternativ kann die Opferschicht erst auf dem Verformungselement aufgebracht und strukturiert werden, wobei das Funktionselement dann in einem nachfolgenden Verfahrensschritt auf der Opferschicht und damit auf dem Verformungselement angeordnet beziehungsweise mit der Opferschicht verbunden wird. Eine bevorzugte Opferschicht enthält oder besteht aus Silizium, Germanium, Zinkoxid, Molybdän und/oder Wolfram. Für ein solches, über eine Opferschicht mit dem Verformungselement in Verbindung stehendes Funktionselement können Materialien, wie beispielsweise hochschmelzende beziehungsweise hochtemperaturfeste Gläser (zum Beispiel Corning Eagle XG^{®}, Corning Lotus Glass^{®}, Schott AF32^{®}) einsetzt werden, die sich bei einer direkten Verbindung mit dem Verformungselement unter der Maßgabe, dass das Verformungselement beziehungsweise die fertiggestellte Komponente nicht beschädigt werden soll, nur mit hohem Aufwand entfernen lassen.

Für bestimmte Anwendungen kann es von Vorteil sein, dass ein oder mehrere Teile des Funktionselements zum Beispiel als rahmenförmige Stabilisierungsstruktur oder Blendenstruktur auf dem Verformungselement beziehungsweise der fertigen optischen Komponente verbleiben.

Auch der Träger wird nach dem Verformen bevorzugt komplett entfernt. In manchen Fällen sind auf dem Träger allerdings die zu verkapselnden Mikro-Systeme angeordnet, so dass ein Bestehen bleiben der Verbindung zwischen Verformungselement und Träger zweckmäßig sein kann.

In einer vorteilhaften Ausgestaltung wird zumindest ein Bereich des Verformungselements und/oder des Funktionselements mit mindestens einer Veredlungsbeschichtung - insbesondere mit einer Entspiegelungsbeschichtung, einer Antistatik-Beschichtung, einer Reflexionsbeschichtung und/oder einer Absorptionsbeschichtung, und/oder funktionalen Oberflächenstrukturen versehen, wodurch sich die Funktionalität der optischen Komponente verbessern lässt.

Bevorzugt eingesetzte Veredlungsbeschichtungen sind Entspiegelungsbeschichtungen, die zum Beispiel Reflexionen an einem Deckel, insbesondere an dessen optischen Fenstern, und damit Strahlungsverluste weiter verringern. Solche Entspiegelungsbeschichtungen lassen sich zum Beispiel durch Schichtsysteme aus Magnesiumfluorid und Titanoxid, oder Siliziumdioxid und Titanoxid realisieren.

Des Weiteren können Antistatik-Beschichtungen, die ein elektrisches Aufladen der optischen Komponente minimieren, Verwendung finden.

Ein für Antistatik-Beschichtungen in optischen Anwendungen geeignetes Material ist ITO (Indiumzinnoxid), da es dotiert eine hohe elektrische Leitfähigkeit aufweist und über einen breiten Wellenlängenbereich eine hohe Transparenz aufweist.

Weiterhin kann es vorteilhaft sein, wenn Reflexionsbeschichtungen, zum Beispiel Metallschichten, als Veredlungsbeschichtungen aufgebracht werden. Diese können nach erfolgter Strukturierung lokal reflektierende Bereiche bilden, zum Beispiel um einen einfallenden Lichtstrahl räumlich zu begrenzen (Blendenfunktion) oder um in Nachbarschaft zu den optischen Fenstern einen statischen Umlenkspiegel zu bilden.

Bevorzugt eingesetzte Veredlungsbeschichtungen sind des Weiteren Absorptionsbeschichtungen, die elektromagnetische Strahlung bestimmter Wellenlänge oder ganzer Wellenlängenbereiche absorbieren.

Funktionale Oberflächenstrukturen sind im Sinne der Erfindung geometrische Modifikationen der Oberfläche im Mikro- und/oder Nanometerbereich, wodurch bestimmte Oberflächeneigenschaften gezielt beeinflusst werden können. So kann durch den bevorzugten Einsatz von Mottenaugenstrukturen (siehe Druckschrift D.G. Stavenga, S. Foletti, G. Palasantzas, K. Arikawa " Light on the moth-eye corneal nipple array of butterflies", Proceedings of the Royal Society B (2006) 273, 661-667, doi: 10.1098/rspb.2005.3369, Published online 6 December 2005), deren strukturellen Abmaße unterhalb der Wellenlänge der in der Anwendung eingesetzten Strahlung liegen, der Brechungsindex einer Grenzschicht -wie sie zum Beispiel zwischen einer Glasoberfläche und der sie umgebenden Luft besteht - verringert werden, weshalb sich Mottenaugenstrukturen zur Entspiegelung von Oberflächen eignen. Eine solche Entspiegelung ist insbesondere dann von Vorteil, wenn sich eine Beschichtung aus Haftungsgründen als ungeeignet erweist.

Mottenaugenstrukturen lassen sich beispielsweise mit Hilfe von Prägeverfahren nach der Formgebung des Verformungselements auf den Oberflächen des Verformungselements erzeugen. Das Einprägen solcher Strukturen in geneigte und/oder verschobene Oberflächen ist allerdings äußerst problematisch. Insbesondere auf geneigten Oberflächen lassen sich Mottenaugenstrukturen durch die Ausnutzung der Fließeigenschaften des Verformungselements herstellen.

Entsprechend werden in einer bevorzugten Ausführungsform Mottenaugenstrukturen als funktionale Oberflächenstrukturen derart erzeugt, dass vor dem Anordnen und/oder dem Inkontaktbringen des Funktionselements auf/mit dem Verformungselement zumindest der Bereich des Funktionselements, der mit dem Verformungselement in Kontakt gebracht wird, mit einer Negativform der Mottenaugenstrukturen versehen wird und nach dem Anordnen und/oder dem Inkontaktbringen des Funktionselements auf/mit dem Verformungselement während der Formgebung des Verformungselements die Mottenaugenstrukturen auf der Kontaktfläche des Verformungselements erzeugt werden, indem die Negativform in dem Funktionselement auf die Kontaktfläche des Verformungselements, insbesondere auf die Transmissionsflächen (beispielsweise eines Prismas), abgeformt wird. Dabei fließt das Material des Verformungselements in die durch die Negativform in dem Funktionselement vorgegebenen Hohlformen, wodurch die entsprechende Oberflächengeometrie entsteht. Die Formgebung des Verformungselements und die Erzeugung der Mottenaugenstrukturen können auch zeitlich separiert beziehungsweise nacheinander in unabhängigen Schritten erfolgen.

In einer weiteren bevorzugten Ausführungsform wird die Veredlungsbeschichtung derart erzeugt, dass vor dem Anordnen und/oder dem Inkontaktbringen des Funktionselements auf/mit dem Verformungselement zumindest der Bereich des Funktionselements, der mit dem Verformungselement in Kontakt gebracht wird, mit der Veredlungsbeschichtung versehen wird und anschließend eine Verbindung zwischen dem Verformungselement und dem Funktionselements durch eine Verbindung zwischen der Veredlungsbeschichtung und dem Verformungselement hergestellt wird oder dass vor dem Anordnen und/oder dem Inkontaktbringen des Funktionselements auf/mit dem Verformungselement die Veredlungsbeschichtung auf das Verformungselement aufgebracht wird und anschließend das Funktionselement auf der Veredlungsbeschichtung angeordnet und/oder mit dieser in Verbindung gebracht wird, wobei nach dem Verformungsschritt das Funktionselement zumindest teilweise entfernt wird und die Veredlungsbeschichtung auf dem Verformungselement verbleibt. Mit dem Aufbringen der Veredlungsbeschichtung auf das Verformungselement vor der Verformung des Verformungselements lässt sich insbesondere auf geneigten optischen Bereichen, wie zum Beispiel der Transmissionsfläche eines Prismas, eine homogene Veredlungsbeschichtung mit geringen Toleranzen in der Dicke der einzelnen Schichten der Veredlungsbeschichtung realisieren. Beim Aufbringen der Veredlungsbeschichtung nach der Verformung des Verformungselements muss die Abscheidung und eine eventuelle Strukturierung der einzelnen Schichten zum Beispiel auf geneigten Bereichen beziehungsweise Oberflächen erfolgen, woraus insbesondere bei der Verwendung von anisotropen Abscheideverfahren Unterschiede in den Dicken der einzelnen Schichten und damit ortsabhängige Differenzen in den Eigenschaften beziehungsweise in der optischen Funktionalität der Veredlungsbeschichtung und damit der optischen Komponente resultieren können.

Eine nach dieser Ausführungsform hergestellte Breitbandentspiegelungsbeschichtung könnte beispielsweise auf einer Schichtfolge aus Siliziumoxid und Siliziumnitrid basieren. In diesem Fall wird zuerst die Siliziumoxidschicht auf das Funktionselement, zum Beispiel aus Silizium, aufgebracht. Anschließend wird auf die Siliziumoxidschicht die Siliziumnitridschicht aufgebracht. Danach wird die Schichtfolge aus Funktionselement, Siliziumoxidschicht und Siliziumnitridschicht mit dem Verformungselement verbunden, indem die Siliziumnitridschicht mit dem Verformungselement in Verbindung gebracht wird. Nach selektiver Entfernung des Funktionselements bleibt eine Schichtfolge aus Verformungselement, Siliziumnitridschicht und Siliziumoxidschicht und damit ein mit einer Entspiegelungsbeschichtung versehenes Verformungselement bestehen. Statt Siliziumnitrid kann alternativ auch Titandioxid verwendet werden.

Auch Kombinationen aus Veredlungsbeschichtung und funktionalen Oberflächenstrukturen, zum Beispiel einer Kombination aus Antistatik-Beschichtung und Mottenaugenstrukturen, können Verbesserungen der Funktionalität der optischen Komponente bewirken.

### Beispiele

Ohne Einschränkung der Allgemeinheit wird die Erfindung anhand von Beispielen nachfolgend näher beschrieben.

Fig. 2-2d zeigen ein mit dem erfindungsgemäßen Verfahren hergestelltes Deckelarray 22 mit geneigten optischen Fenstern 3 und die Verwendung zur Verkapselung von Mikrospiegeln 25.

Fig. 3a-3h zeigen die Schrittfolge eines Ausführungsbeispiels zur Strukturierung eines Glaswafers 1 zur Herstellung von Öffnungen 8a mittels Glasfließens.

Fig. 4a-4i, Fig. 4k und Fig. 4m zeigen die Schrittfolge eines Ausführungsbeispiels zur Herstellung eines Deckelarrays 22 mit geneigten beziehungsweise geneigten und verschobenen optischen Fenstern 3 nach dem erfindungsgemäßen Verfahren für unterschiedlich gestaltete Verformungsbereiche und unter Verwendung unterschiedlicher Drücke.

Fig. 5a-5g zeigen die Schrittfolge eines weiteren Ausführungsbeispiels zur Herstellung eines Deckelarrays 22 mit geneigten optischen Fenstern 3 nach dem erfindungsgemäßen Verfahren unter Verwendung eines als Träger 5 fungierenden Werkzeugs beziehungsweise Auflage 5 mit Entlüftungskanälen 23.

Fig. 6a-6f und Fig. 7a-7e zeigen die Schrittfolge weiterer Ausführungsbeispiele zur Herstellung eines Deckelarrays 22 mit geneigten optischen Fenstern 3 nach dem erfindungsgemäßen Verfahren unter Verwendung einer Formgebungsvorrichtung 30 zur Krafteinbringung.

Fig. 8a-e zeigen die Schrittfolge eines Ausführungsbeispiels zur Herstellung eines Deckelarrays 22 mit geneigten optischen Fenstern 3 nach dem erfindungsgemäßen Verfahren unter Verwendung eines Trägers 5 mit Unterstützungsstrukturen 21.

Fig. 9a-9e zeigen die Schrittfolge eines weiteren Ausführungsbeispiels zur Herstellung eines Deckelarrays 22 mit geneigten optischen Fenstern 3 nach dem erfindungsgemäßen Verfahren unter Verwendung einer Stabilisierungsschicht 20.

Fig. 10a-10i, Fig. 11a-11f, Fig. 12a-12b und Fig. 13a-13f zeigen die Schrittfolge weiterer Ausführungsbeispiele zur Herstellung eines Deckelarrays 22 mit geneigten beziehungsweise geneigten und verschobenen optischen Fenstern 3 nach dem erfindungsgemäßen Verfahren unter Verwendung eines oder mehrerer Hohlräume 12, 13, insbesondere zwischen dem Träger 5 und dem Verformungselement 1.

Fig. 14a-14d zeigen die Schrittfolge eines weiteren Ausführungsbeispiels zur Herstellung eines Deckelarrays 22 mit geneigten und verschobenen optischen Fenstern 3 nach dem erfindungsgemäßen Verfahren unter Verwendung von Vertiefungen 10 im Träger.

Fig. 15a-15d zeigen die Schrittfolge eines weiteren Ausführungsbeispiels zur Herstellung eines Deckelarrays 22 mit geneigten und verschobenen optischen Fenstern 3 nach dem erfindungsgemäßen Verfahren unter Verwendung von Hohlräumen 11 zwischen dem Verformungselement 1 und den Funktionselementen 2.

Fig. 16a-16f zeigen die Schrittfolge eines Ausführungsbeispiels zur Herstellung eines Arrays von Prismen oder geneigten Spiegeln 22b nach dem erfindungsgemäßen Verfahren unter Verwendung eines beidseitig planen Verformungselements 1.

Fig. 17a-17g zeigen die Schrittfolge eines Ausführungsbeispiels zur Herstellung eines Arrays von Prismen oder geneigten Spiegeln 22b nach dem erfindungsgemäßen Verfahren unter Verwendung inselförmiger Verformungselemente 1.

Fig. 18a-18b und Fig. 19a-19b zeigen die Schrittfolge weiterer Ausführungsbeispiele zur Herstellung eines Deckelarrays 22 mit verschobenen optischen Fenstern 3 nach dem erfindungsgemäßen Verfahren.

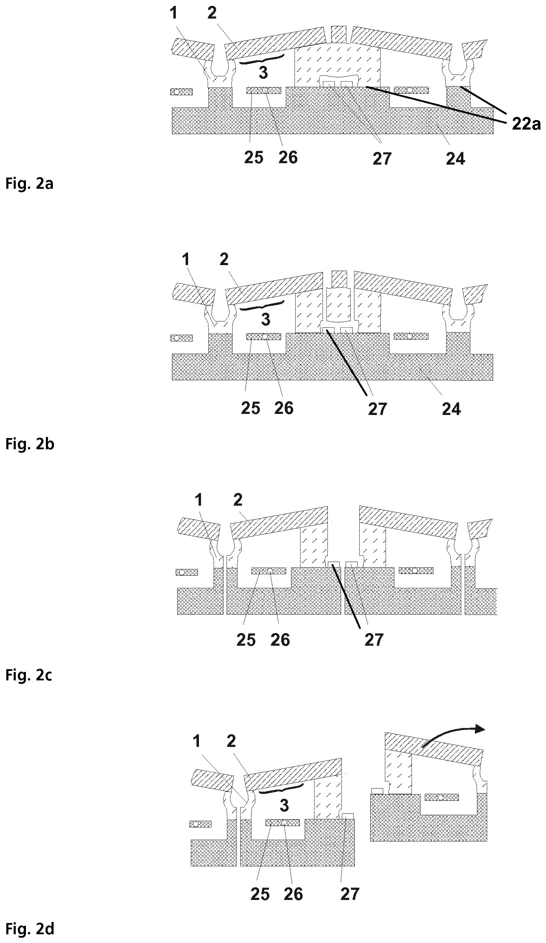

Fig. 2 zeigt ein mit dem erfindungsgemäßen Verfahren hergestelltes Deckelarray 22 mit geneigten optischen Fenstern 3, wobei ein geeignetes Deckelarray 22 zum Verkapseln eines gesamten Siliziumwafers 24 verwendet werden kann.

Die geneigten optischen Fenster 3 sind in einem zweidimensionalen Array angeordnet und weisen in Bezug auf die jedes Fenster 3 umlaufende Kontaktierungsfläche 22a des Deckelarrays 22 üblicherweise eine Neigung zwischen etwa 5° und etwa 20°, bevorzugt etwa 15°, auf. Die jedes geneigte optische Fenster 3 umlaufende Kontaktierungsfläche 22a ist rahmenförmig geschlossen und eben ausgeführt. Entsprechend dimensionierte rahmenförmig geschlossene ebene Flächen sind auf dem Trägersubstrat beziehungsweise Siliziumwafer 24 als Gegenkontaktierungsflächen vorgesehen, wie Fig. 2a zeigt. Dadurch wird eine zur Umgebung hermetisch dicht abschließende Verbindung ermöglicht.

Die geneigten optischen Fenster 3 sind beidseitig mit einer Entspiegelungsbeschichtung aus einem Schichtsystem aus Siliziumdioxid und Titanoxid versehen.

Nach dem Aufbonden des Deckelarrays 22 auf den Siliziumwafer 24 werden die Kontaktpads 27, die auf dem Siliziumwafer 24 angeordnet sind, freigelegt und die Chips vereinzelt, wodurch im Ergebnis ein mit einem Deckel 22 verkapselter Mikrospiegel 25 entsteht Fig. 2a-2d.

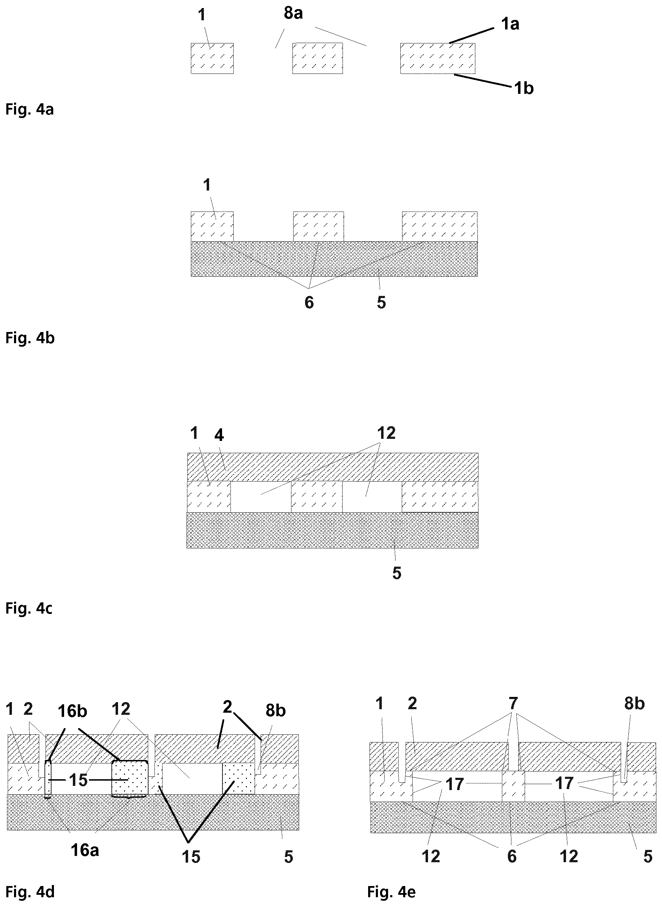

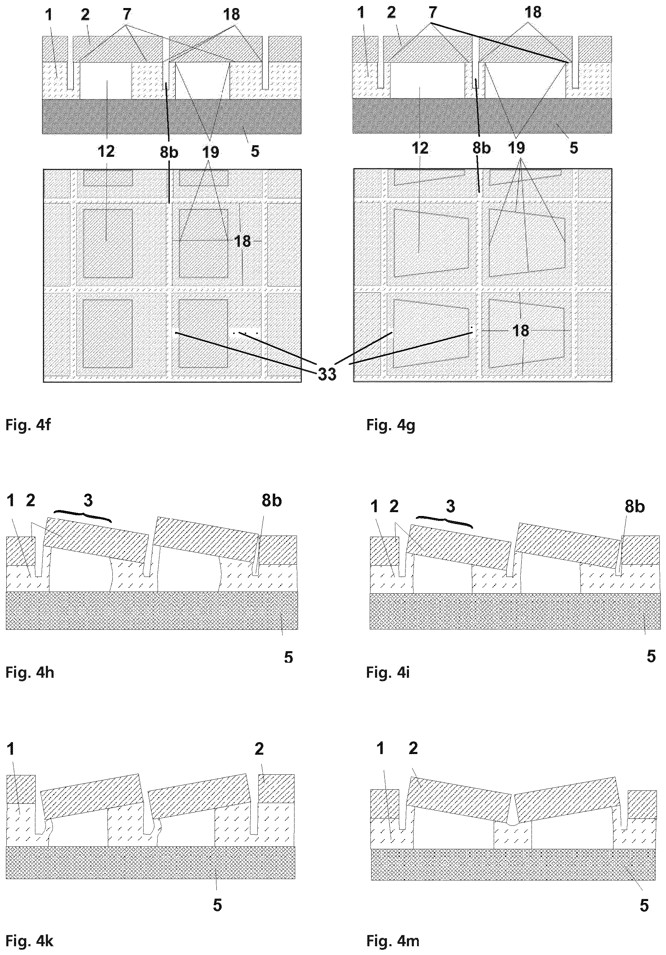

Fig. 4a-4m zeigen die Schrittfolge mehrerer Ausführungsbeispiele zur Herstellung eines Deckelarrays beziehungsweise Deckels 22 mit geneigten beziehungsweise geneigten und verschobenen optischen Fenstern 3 nach dem erfindungsgemäßen Verfahren. Das zum Prozessbeginn bereitgestellte Verformungselement 1 ist ein beidseitig ebener, planparallele Substratebenen 1a, 1b aufweisender Glaswafer aus Borsilikatglas, der eine Dicke zwischen etwa 500 µm und etwa 1000 µm, in diesem Fall 725 µm, aufweist. Beide Waferseiten beziehungsweise Waferebenen 1a, 1b des Glaswafers 1 sind poliert und weisen damit eine hohe Oberflächenqualität mit einer quadratischen Oberflächenrauigkeit von etwa 1 bis 3 nm auf. Zudem weißt der Glaswafer 1 rechteckige (Fig. 4f) oder trapezförmige (Fig. 4g) Öffnungen 8a auf, die durch einen Sandstrahl- oder Fräsprozess realisiert werden.

Eine Seite 1b des Glaswafers 1 wird mit einem Siliziumwafer 5, der als Träger 5 fungiert, durch anodisches Bonden verbunden, wobei der Prozess zu einer hermetisch dichten Verbindung führt (Fig. 4b). Die andere Seite 1a des Glaswafers 1 wird mit einem 850 µm dicken weiteren Glaswafer 4 aus hochtemperaturfestem beziehungsweise höher schmelzenden Glas beziehungsweise Silikatglas (z.B. Corning Eagle XG^{®}, Corning Lotus Glas^{®}, Schott AF32^{®}, Hoya SD2^{®}), der als Funktionsschicht 4 fungiert, durch Fusion Bonding oder thermisches Bonden hermetisch dicht verbunden (Fig. 4c). Alternativ kann der Verbindungsschritt mittels anodischen Bondens erfolgen, wozu in einem vorherigen Schritt der weitere Glaswafer 4 mit einer leitfähigen Schicht, wie zum Beispiel Polysilizium, beschichtet wird.

Das Verbinden der beiden Glaswafer 1, 4 erfolgt bei Temperaturen von etwa 400°C und einem Druck von etwa 10 bis 20 mbar oder etwa 800 bis 1000 mbar.

Der weitere Glaswafer 4 weist beidseitig ebene, planparallele Substratebenen auf, wobei die beiden Waferseiten beziehungsweise Waferebenen poliert ausgeführt sind und eine quadratischen Oberflächenrauigkeit von etwa 1 bis 3 nm aufweisen.

Durch die Verbindung des Glaswafers 1 mit dem Siliziumwafer 5 und dem weiteren Glaswafer 4 entstehen auf Grund der Öffnungen 8a im Glaswafer 1 hermetisch abgeschlossene Hohlräume 12 (Fig. 4c).

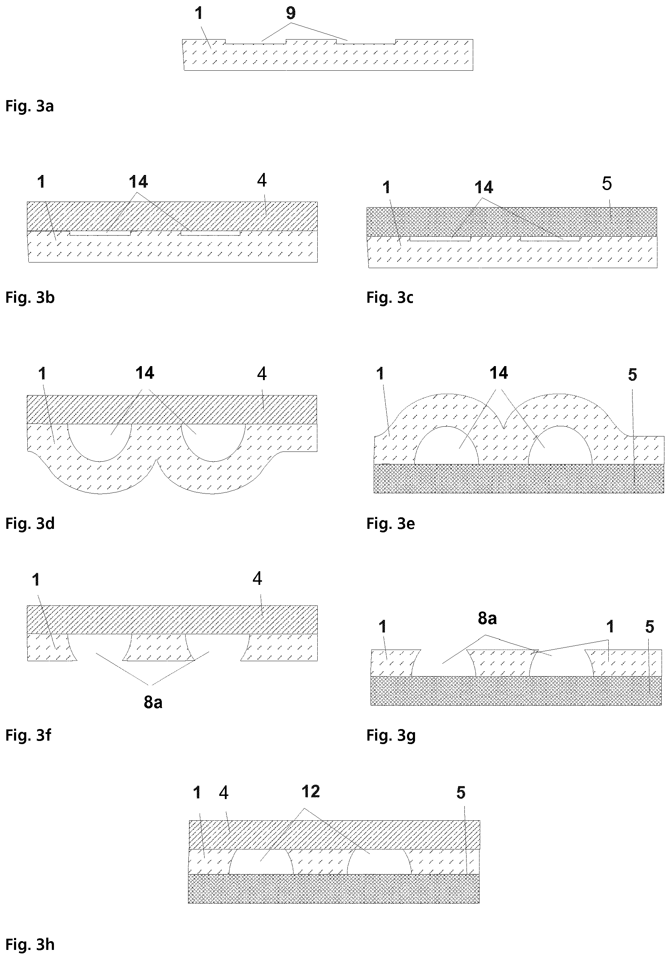

Eine alternative Möglichkeit zur Erzeugung eines Glaswafers 1 mit Öffnungen 8a ist in den Fig. 3a-3h gezeigt. Dabei werden in einem ersten Schritt durch Ätzen, Sandstrahlen, Bohren, Fräsen und/oder Laserstrahlbearbeitung Behelfsvertiefungen 9 im Glaswafer 1 erzeugt (Fig. 3a). Durch Verbinden des Glaswafers 1 mit einem weiteren Glaswafer 4 (Fig. 3b), der im weiteren Verfahren die Basis für die Funktionselemente 2 darstellen und entsprechend als Funktionssubstrats beziehungsweise Funktionsschicht 4 fungieren kann, mittels Fusion Bonding oder mit einem Siliziumwafer 5 (Fig. 3c), der im weiteren Verfahren als Träger 5 fungieren kann, mittels anodischen Bondens werden die Behelfsvertiefungen 9 im Glaswafer 1 hermetisch dicht verschlossen. Alternativ können statt den Behelfsvertiefungen 9 im Glaswafer 1 auch Behelfsvertiefungen 9 im Siliziumwafer 5 oder im weiteren Glaswafer 4 ausgebildet sein, um zwischen dem Glaswafer 1 und dem Siliziumwafer 5 oder dem weiteren Glaswafer 4 hermetisch dicht abgeschlossene Hohlräume 14 zu generieren.

Im Rahmen des Verbindungsschritts wird in den Hohlräumen 14 ein Druck von etwa 800 bis 1000 mbar erzeugt. Durch das Erwärmen des Glaswafers 1 aus Borsilikatglas auf 700°C und damit auf eine Temperatur, die im Bereich der Erweichungstemperatur von Borsilikatglas liegt, wird der Glaswafer 1 weich beziehungsweise fließfähig. Zudem erhöht sich der Druck in den Hohlräumen 14 auf etwa 1200 bis 1600 mbar. Da das Erwärmen bei atmosphärischem Luftdruck erfolgt, wird durch den Überdrück in den Hohlräumen 14 eine Verformung des Glaswafers 1 bedingt (Fig. 3d, Fig. 3e). Durch Schleifen und Polieren werden die Hohlräume 14 geöffnet (Fig. 3f, Fig. 3g) und die Öffnungen 8a im Glaswafer 1 erzeugt. Die abgeschliffene Seite des Glaswafers 1 kann dann mit einem Träger 5 oder einem Funktionssubstrat 4 verbunden werden, um die Öffnungen 8a zu verschließen und hermetisch abgeschlossene Hohlräume 12 zu erzeugen (Fig. 3h).

Die Strukturierung des weiteren Glaswafers 4 zur Erzeugung von mehreren Funktionselementen 2, die zum Beispiel als optische Fenster 3 fungieren können, sowie zur Realisierung eines gewünschten Verformungsbereichs 15 (Fig. 4d - fein gepunkteter Bereich des Glaswafers 1) erfolgt mittels eines Sägeschritts, beim dem die hermetisch abgeschlossenen Hohlräume 12 erhalten bleiben (Fig. 4d). Dabei wird der weitere Glaswafer 4 derart gesägt, dass jeweils ein erzeugtes Funktionselement 2 einen der Hohlräume 12 verschließt (Fig. 4f und 4g). Alternativ können die Funktionselemente 2 derart erzeugt werden, dass jeweils ein Funktionselement 2 die Hohlräume 12 verschließt, die gemäß Fig. 4f beziehungsweise Fig. 4g in einer Spalte beziehungsweise vertikal angeordnet sind.

Zudem erfolgt durch denselben Sägeschritt eine Strukturierung des Glaswafers 1, bei dem Vertiefungen 8b erzeugt werden, wodurch der Verformungsbereich 15, insbesondere rahmenförmig, gestaltet und Einfluss auf den Verformungswiderstand genommen wird. Insbesondere wird der Verformungsbereich 15 dadurch bereichsweise mit weiteren Oberflächenbereichen 17 versehen, um den lokalen Verformungswiderstand dieser Bereiche des Verformungsbereichs 15 zu verringern (Fig. 4e) und das Verfahren in Bezug auf den materiellen und den zeitlichen Aufwand zu optimieren.

Zudem beziehungsweise alternativ kann eine Widerstandsasymmetrie des Verformungsbereichs 15 gemäß Fig. 4d dadurch erzielt werden, dass die Breite des rahmenförmigen Verformungsbereichs 15 variiert wird. Die Draufsichten der Fig. 4f und 4g zeigen die unterschiedlich gestalteten zweiten Kontaktflächen 7 zwischen dem Glaswafer 1 und den Funktionselementen 2 nach dem Sägeschritt, wobei die Gestaltung der zweiten Kontaktflächen 7 maßgebend für die Gestalt des Verformungsbereichs 15 ist.

Zur Gewährleistung der gewünschten Widerstandsasymmetrie werden der äußere Rand 18 und der innere Rand 19 einer der rahmenförmigen zweiten Kontaktflächen 7 jeweils durch ein Rechteck beschrieben, deren Umkreismittelpunkte nicht zusammenfallen, wobei eine Symmetrieachse des den inneren Rand 19 beschreibenden Rechtecks und eine Symmetrieachse des den äußeren Rand 18 beschreibenden Rechtecks auf derselben Gerade liegen. Dadurch sind zwei sich gegenüberliegende Schenkel der rahmenförmigen zweiten Kontaktfläche 7 gleich und die anderen beiden Schenkel sind unterschiedlich breit ausgeführt (Fig. 4f).

In der Ausführungsform nach Fig. 4g wird der äußere Rand 18 einer der rahmenförmigen zweiten Kontaktflächen 7 durch ein Rechteck beschrieben, wohingegen der innere Rand 19 durch ein gleichschenkliges Trapez beschrieben wird. Dadurch sind zwei sich gegenüberliegende Schenkel der rahmenförmigen zweiten Kontaktfläche 7 zulaufend ausgeführt und die andern beiden Schenkel nicht, wodurch unter Berücksichtigung eines entsprechenden Trägers 5 beziehungsweise einer entsprechend gestalteten ersten Kontaktfläche 6 ebenfalls eine Widerstandsasymmetrie des Verformungsbereichs 15 erreicht wird.

Beim folgenden Verfahrensschritt wird das Schichtsystem aus Glaswafer 1, den Funktionselementen 2 und dem Siliziumwafer 5 erwärmt. Bei Verwendung eines Glaswafers 1 aus Borsilikatglas, mit einer Erweichungstemperatur von etwa 820 °C, wird das Schichtsystem auf etwa 700 °C erwärmt, wodurch der Glaswafer 1 weich wird und zu fließen beginnt. Da die Erweichungstemperatur der Funktionselemente 2, die aus einem Silikatglas (zum Beispiel Corning Eagle XG^{®}) bestehen, bei 971°C liegt und damit wesentlich höher als die Erweichungstemperatur des Glaswafers 1 ist, bleibt die Form der Funktionselemente 2 erhalten, wodurch zudem eine optimale Übertragung der Verformungskraft auf den Glaswafer 1 gewährleistet ist.

Durch die im Vergleich zum Bondprozess erhöhte Temperatur steigt der Druck in den Hohlräumen 12 von etwa 10 bis 20 mbar auf etwa 20 bis 30 mbar oder von etwa 800 bis 1000 mbar auf etwa 1200 bis 1600 mbar. Der entsprechend herrschende Unterdruck oder Überdruck in Bezug auf den atmosphärischen Luftdruck der Umgebung führt zu einer auf den Glaswafer 1, insbesondere den Verformungsbereich 15, wirkenden Kraft, die eine Verformung des Glaswafers 1 beziehungsweise der Verformungsbereiche 15 bedingt.

Durch die Widerstandsasymmetrie des jeweiligen Verformungsbereichs 15 kommt es zu einem Neigen (Fig. 4i - Überdruck im Hohlraum 12, Fig. 4k - Unterdruck im Hohlraum 12 ) oder zu einem Neigen und Verschieben (Fig. 4h und Fig. 4m - Überdruck im Hohlraum 12) des den jeweiligen Hohlraum 12 begrenzenden Funktionselements 2. Der Verformungsschritt wird bei Kontakt des jeweiligen Funktionselements 2 mit einer Auslenkungsbegrenzung, zum Beispiel einem benachbarten Funktionselement (Fig. 4m), oder nachdem der Druck in den Hohlräumen 12 verformungsgedingt den Wert des Umgebungsdrucks erreicht hat, abgebrochen.

In einem weiteren Schritt wird der Siliziumwafer 5 vom Glaswafer 1 durch nasschemisches Ätzen in Kaliumhydroxid selektiv entfernt und das Deckelarray 22 aus geformtem Glaswafer 1 und Funktionselementen 2 vereinzelt, wobei der Vereinzelungsprozess alternativ auch nach dem Verkapselungsprozess erfolgen kann, wie in Fig. 2a-2d bereits beschrieben wurde.

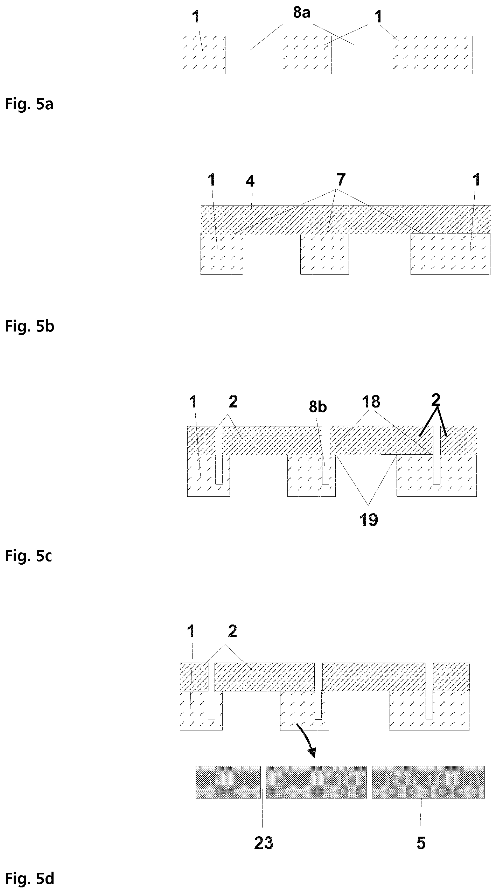

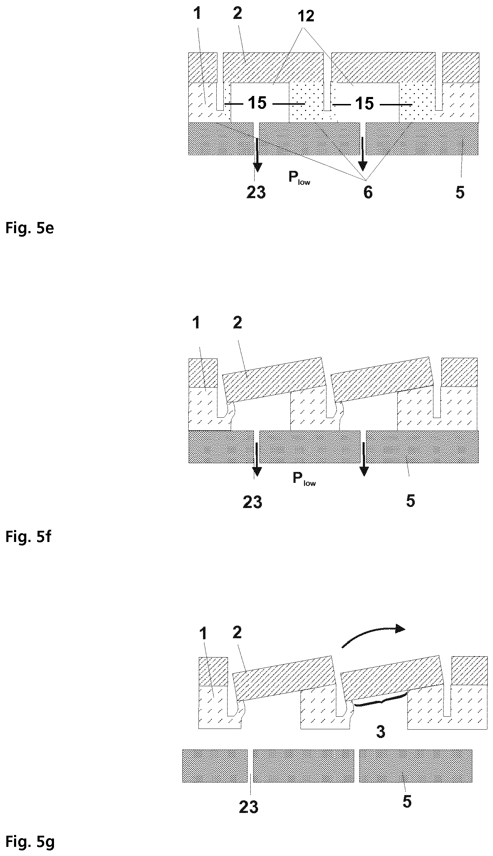

In einem weiteren Ausführungsbeispiel nach Fig. 5a-5g wird statt eines Siliziumwafers als Träger 5 ein Werkzeug beziehungsweise eine Auflage mit Entlüftungskanälen 23 verwendet. Nach dem Verbinden des Glaswafers 1 aus Borsilikatglas mit dem weiteren Glaswafer 4 (Fig. 5b) und der Strukturierung beider Glaswafer 1, 4 durch einen Sägeschritt zur Erzeugung von Funktionselementen 2 und zur Gestaltung der Verformungsbereiche 15 (Fig. 5c) wird der strukturierte Glaswaferverbund aus Glaswafer 1 und den Funktionselementen 2 justiert in Kontakt mit der Auflage 5, die als Träger 5 fungiert, gebracht, wobei die Auflage 5 aus Graphit besteht beziehungsweise wobei zumindest die Oberflächenbereiche der Auflage 5, die mit dem strukturierten Glaswaferverbund 1, 2 in Kontakt gebracht werden, mit Graphit beschichtet sind (Fig. 5d). Die Entlüftungskanäle 23 der Auflage 5 sind an die Struktur des strukturierten Glaswaferverbunds 1, 2 angepasst, so dass jeder der durch den strukturierten Glaswaferverbund 1, 2 und die Auflage 5 verschlossenen Hohlräume 12 mit mindestens einem Entlüftungskanal 23 in Verbindung steht (Fig. 5e). Während des folgenden Erwärmen und Verformens wird über die Entlüftungskanäle 23 mittels Vakuumpumpe in den Hohlräumen 12 ein Druck erzeugt, der unter dem Umgebungsdruck (zum Beispiel atmosphärischer Luftdruck) liegt. Durch die dadurch erzielte Kraftwirkung auf die Funktionselemente 2 beziehungsweise auf die Verformungsbereiche 15 und durch die Ausgestaltung der Verformungsbereiche 15 wird ein auf jedes Funktionselement 2 wirkendes resultierendes Drehmoment erzeugt, was in Verbindung mit dem durch das Erwärmen bedingte fließfähige Borsilikatglas des Glaswafers 1 zum Neigen beziehungsweise Verkippen der Funktionselement 2 in Richtung der Auflage 5 führt (Fig. 5f). Nachdem die gewünschte Neigung erreicht ist, wird in den Hohlräumen 12 über die Entlüftungskanäle 23 Umgebungsdruck eingestellt, so dass der geformte Glaswaferverbund 1, 2 von der Auflage 5 entfernt werden kann (Fig. 5g). Die Auflage 5 kann für einen weiteren Prozessdurchlauf wiederverwendet werden.

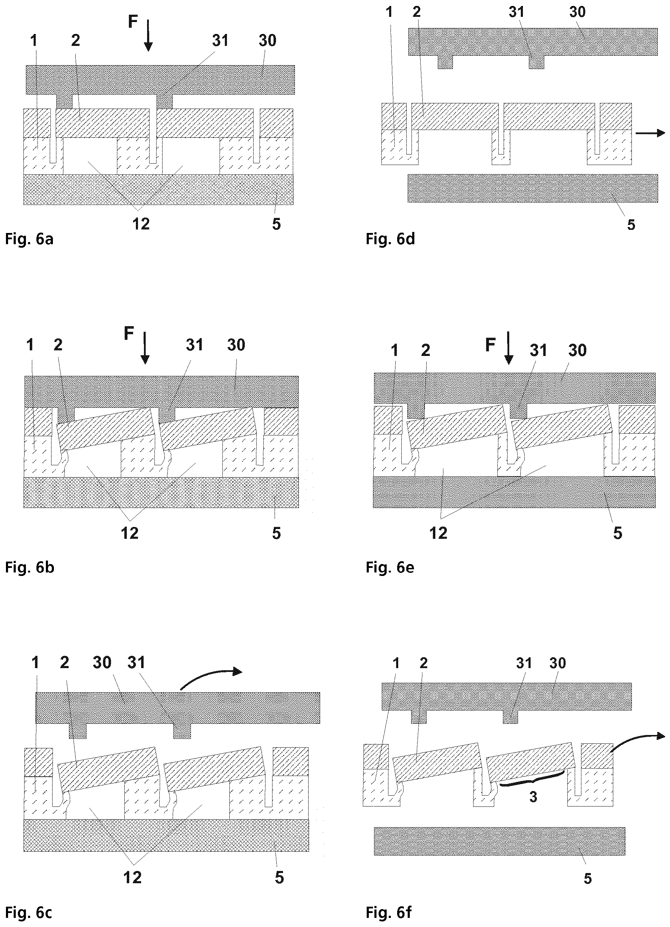

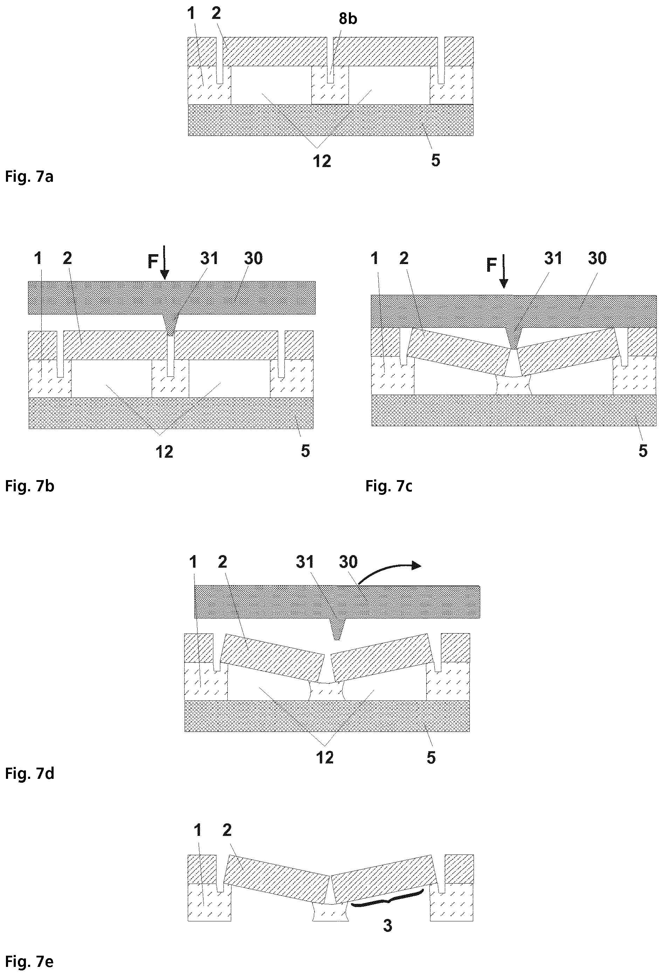

Neben der Gewährleistung einer Druckdifferenz zur Erzeugung einer Kraftwirkung kann die Verformungskraft auch über eine Formgebungsvorrichtung 30 eingebracht werden, wie die Fig. 6a-6f und Fig. 7a-7e zeigen.

Die Fig. 6a-6c zeigen eine Variante unter Verwendung eines Siliziumwafers als Träger 5 und die Fig. 6d-6f zeigen eine Variante unter Verwendung einer Auflage als Träger 5. Sowohl die Formgebungsvorrichtung 30 als auch die Auflage 5 bestehen dabei aus einem Material oder sind mit einem Material beschichtet, welches beim Erwärmen und Verformen möglichst wenig am strukturierten beziehungsweise geformten Glaswaferverbund 1, 2 anhaftet, wie zum Beispiel Graphit. Durch eine entsprechende Justage der Formgebungsvorrichtung 30 kann die Verformungskraft gezielt derart eingebracht werden, dass ein Neigen der Funktionselemente 2 beziehungsweise der optischen Fenster 3 gewährleistet wird. Durch jeweils widerstandsasymmetrische Verformungsbereiche 15 (Fig. 6a-6c) kann ein Neigen zusätzlich unterstützt werden. Zudem kann die Formgebungsvorrichtung 30 derart gestaltet sein, dass sie gleichzeitig als Anschlag fungiert, um einen vorgegebenen Neigungswinkel des optischen Fensters 3 präzise zu realisieren. Alternativ wird die Verformungskraft aufrechterhalten, bis die gewünschte Neigung der Funktionselement 2 erreicht ist. Nach dem Erwärmen und Verformen wird die Formgebungsvorrichtung 30 vom geformten Glaswaferverbund 1, 2 entfernt, so dass der geformte Glaswaferverbund 1, 2 von der Auflage 5 gelöst (Fig. 6f) oder der Siliziumwafer 5 entfernt werden kann.

In Fig. 7a-7e ist die Verwendung einer Formgebungsvorrichtung 30 mit einem keilförmigen Stempelelement 31 gezeigt. Insbesondere die Oberfläche des Stempelelements 31 besteht wiederum aus Graphit oder ist mit Graphit beschichtet und ermöglicht auf Grund seiner Form ein selbstjustiertes Aufsetzen der Formgebungsvorrichtung 30 auf den strukturierten Glaswaferverbund 1, 2. Die Formgebungsvorrichtung 30 kann wiederum als Anschlag fungieren, so dass ein präziser Neigungswinkel der Funktionselemente 2 eingestellt werden kann.

In einem weiteren Ausführungsbeispiel weißt das Stempelelement 31 eine geneigte Stempelfläche auf, die die für die optischen Fenster 3 gewünschte Neigung aufweist.

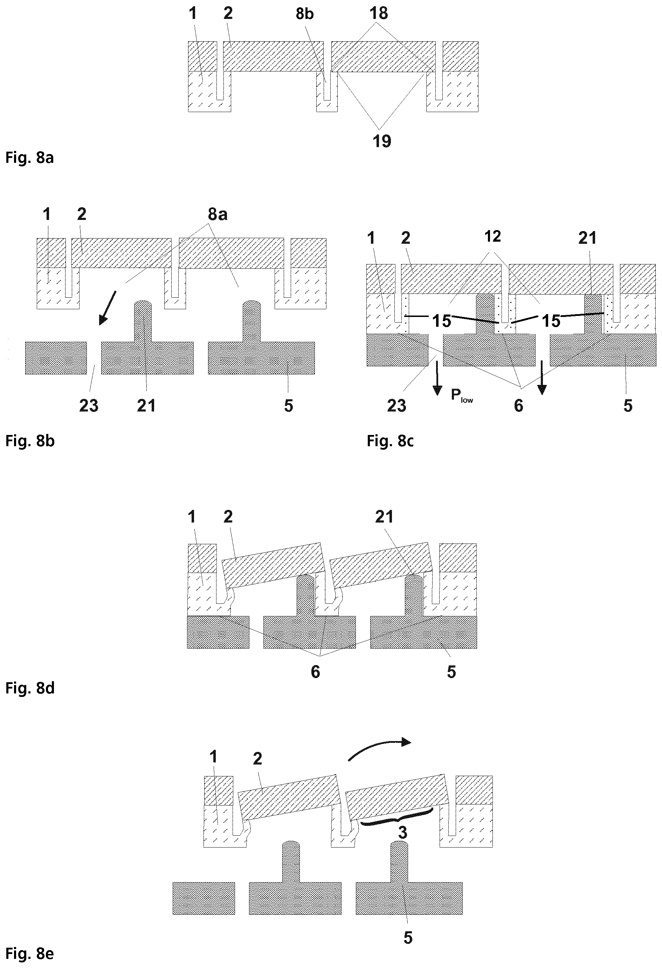

Gemäß des Ausführungsbeispiels nach den Fig. 8a-8e wird der strukturierte Glaswaferverbund 1, 2 (Fig. 8a) aus dem Borsilikatglaswafer 1 und den Funktionselementen 2 (zum Beispiel optische Fenster 3) mit einer Auflage 5 justiert in Kontakt gebracht (Fig. 8b-8c), die neben Entlüftungskanälen 23 Unterstützungsstrukturen 21 aufweist. Nachdem der Kontakt herstellt wurde, wird über die Entlüftungskanäle 23 mittels Vakuumpumpe ein Druck in den Hohlräumen 12 eingestellt, der unterhalb des Umgebungsdrucks liegt. Durch das Erwärmen des Glaswafers 1 bis in die Nähe seiner Erweichungstemperatur wird dieser in einen fließfähigen Zustand gebracht, so dass der Verformungsbereich 15 durch die durch die Druckdifferenz bedingte Kraftwirkung auf den strukturierten Glaswaferverbund 1, 2 verformt wird. Durch eine gezielte lokale Unterstützung des strukturierten Glaswaferverbunds 1, 2 mittels der Unterstützungsstrukturen 21 können resultierende Drehmomente auf die Funktionselemente 2 gewährleistet und ein Neigen der Funktionselemente 2 relativ zur Auflage 5 beziehungsweise zur Ausgangslage der Funktionselemente 2 erreicht werden.

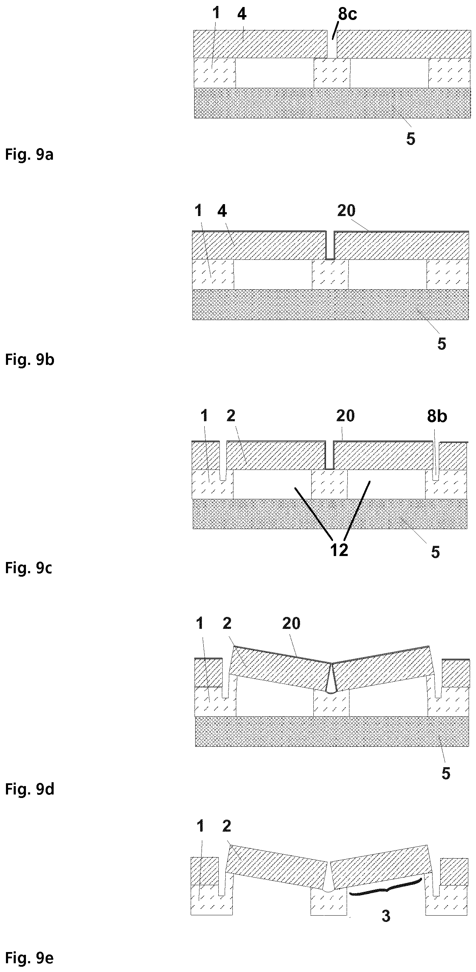

Die Fig. 9a-9e zeigen ein Ausführungsbeispiel zur Herstellung eines Deckelarrays 22 mit geneigten optischen Fenstern 3, bei dem das Neigen der Funktionselemente 2 durch Verwendung einer Stabilisierungsschicht 20 unterstützt wird. Dabei wird der Glaswaferverbund 1, 4 aus Glaswafer 1 und weiteren Glaswafer 4 nach dem Verbinden mit einem Siliziumwafer als Träger 5 derart strukturiert, dass in einem ersten Sägeschritt die Bereiche des weiteren Glaswafers 4 strukturiert werden, die beim Schritt des Erwärmen und Verformens möglichst wenig ausgelenkt werden sollen (Fig. 9a). Der Sägeschnitt wird so tief ausgeführt, dass die erzeugte Vertiefung 8c teilweise durch den Glaswafer 1 begrenzt wird. Anschließend wird der so strukturierte weitere Glaswafer 4 und die Vertiefung 8c mit einer Stabilisierungsschicht 20 aus Silizium beschichtet. Die Abscheidung der etwa 1 bis 5 µm dicken Siliziumschicht 20 kann mittels PVD- oder CVD-Verfahren erfolgen. Alternativ kann der Sägeschnitt so tief ausgeführt werden, dass ein Teil des weiteren Glaswafers 4 als Stabilisierungsschicht bestehen bleibt. Die Stabilisierungsschicht 20 wirkt durch ihre Verformung der Verformungskraft zusätzlich entgegen und stabilisiert zudem den durch sie bedeckten Bereich des Glaswafers 1. Da dieser Bereich des Glaswafers 1 an den Verformungsbereich 15 angrenzt und mit diesem in einer gegenseitigen Wechselwirkung steht, bewirkt die linienförmig an den Verformungsbereich 15 angrenzende Stabilisierungsschicht 20 zusätzlich eine lokale Erhöhung des Verformungswiderstands des Verformungsbereichs 15.

In einem weiteren Sägeschritt erfolgt die finale Strukturierung des Glaswaferverbunds 1, 4 zur Erzeugung der Funktionselemente 2 beziehungsweise der optischen Fenster 3. Die Bereiche der Verformungsbereiche 15, die durch diesen Sägeschritt gestaltet werden, werden nicht durch die Siliziumschicht 20 stabilisiert (Fig. 9c), da sie für eine stärkere Auslenkung vorgesehen sind. Dadurch wird ein Neigen der Funktionselemente 2 beim Erwärmen und Verformen gewährleistet (Fig. 9d bei Verwendung eines Überdrucks in den Hohlräumen 12). Die Siliziumschicht 20 stabilisiert und fixiert zudem die Funktionselemente 2 in ihrer Lage. Durch die Verwendung einer Stabilisierungsschicht 20 können die Bereiche der Verformungsbereiche 15, die für eine geringere Auslenkung vorgesehen sind und die entsprechend einen höheren Verformungswiderstand aufweisen sollen, platzsparender (zum Beispiel schmaler) ausgelegt werden.

Abschließend wird der Siliziumträger 5 entfernt (Fig. 9e) und der geformte Glaswaferverbund 1, 2 kann direkt oder nach Verkapselung eines kompletten Wafers vereinzelt werden.

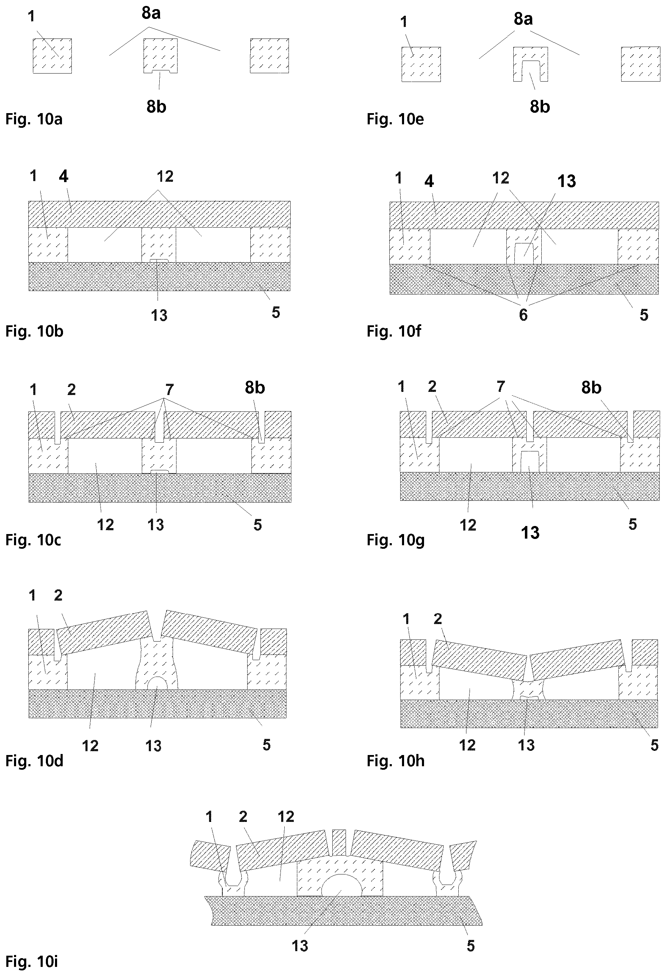

In den Fig. 10a-13f sind die Schrittfolgen verschiedener Ausführungsbeispiele zur Herstellung eines Deckelarrays 22 mit geneigten beziehungsweise verschobenen und geneigten optischen Fenstern 3 dargestellt, bei denen ein Hohlraum 13 zwischen dem Träger 5 und dem Verformungselement 1 zur Gewährleistung der gewünschten Neigung beziehungsweise Verschiebung und Neigung der Funktionselemente 2 beziehungsweise der optischen Fenster 3 Anwendung findet.

Ein oder mehrere Hohlräume 13 zwischen dem Träger 5 und dem Verformungselement 1 können dadurch gebildet werden, dass der Glaswafer 1 aus Borsilikatglas und/oder der Siliziumwafer 5 mit ein oder mehreren Vertiefungen 8b, 10 ausgeführt werden, die nach dem Kontakt beziehungsweise dem Verbinden des Glaswafers 1 mit dem Siliziumwafer 5 ein oder mehrere Hohlräume 13 einschließen. Die Verbindung zwischen dem Glaswafers 1 und dem Siliziumwafer 5 wird durch Fusion Bonding hergestellt, wodurch der Hohlraum 13 hermetisch verschlossen und so ein Druck eingestellt werden kann, der sowohl vom Umgebungsdruck als auch vom Druck in den Hohlräumen 12 verschieden sein kann. Der Druck in den Hohlräumen 12 kann dann beim Verbinden des weiteren Glaswafers 4 mit dem Glaswafer 1 eingestellt werden.

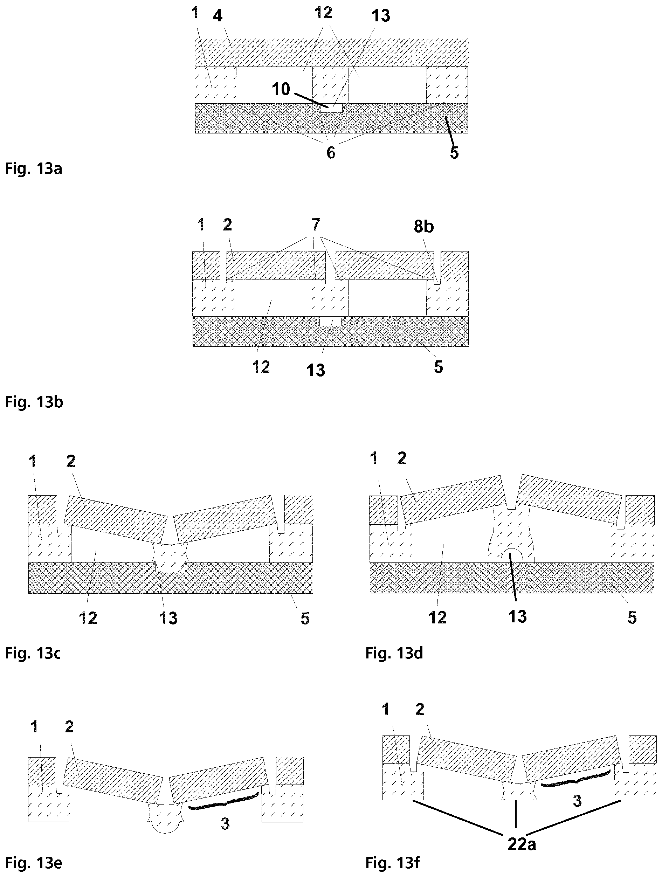

Der Druck in den Hohlräumen 12 zwischen dem Funktionselement 2, dem Glaswafer 1 und dem Siliziumwafer 5 wird so eingestellt, dass beim Verfahrensschritt des Erwärmen und Verformens der Druck in den Hohlräumen 12 dem Umgebungsdruck entspricht. Dadurch besteht zwischen den Hohlräumen 12 und der Umgebung keine Druckdifferenz, die die Funktionselemente 2 beziehungsweise die optischen Fenster 3 mechanisch belasten würde. Durch die damit erzielte Reduktion der mechanischen Belastung der Funktionselemente 2 kann ihre ursprüngliche Form auch während des Erwärmen und Verformens besonders gut erhalten werden. Eine die Verformung bedingende Kraftwirkung wird durch die Druckdifferenz zwischen dem Hohlraum 13 und der Umgebung beziehungsweise den Hohlräumen 12 erzielt. Ein Überdruck im Hohlraum 13 von etwa 100 bis 200 mbar führt dann zu einer Auslenkung der Funktionselemente 2 und damit der optischen Fenster 3 gemäß Fig. 10d und Fig. 13d, ein Unterdruck von etwa 100 bis 200 mbar führt zu einer Auslenkung gemäß Fig. 10h und Fig. 13c. Im Falle eines Überdrucks im Hohlraum 13 kann das Erwärmen und Verformen in einem Vakuumofen durchgeführt werden, wobei in den Hohlräumen 12 derselbe Druck wie im Vakuumofen eingestellt ist. Im Falle eines Unterdrucks im Hohlraum 13 kann das Erwärmen und Verformen bei atmosphärischem Luftdruck im Ofen als auch in den Hohlräumen 12 durchgeführt werden. Das Ergebnis nach Fig. 13e wird durch Schleifen und/oder Polieren nachbearbeitet, um ebene Kontaktierungsflächen 22a für den Verkapselungsschritt zur Verfügung zu stellen (Fig. 13f).

In einem weiteren Ausführungsbeispiel besteht wären des Erwärmen und Verformens im Vergleich zum Umgebungsdruck im Hohlraum 13 ein Überdruck und in den Hohlräumen 12 ein Unterdruck, woraus eine Verformung gemäß Fig. 10i resultiert.

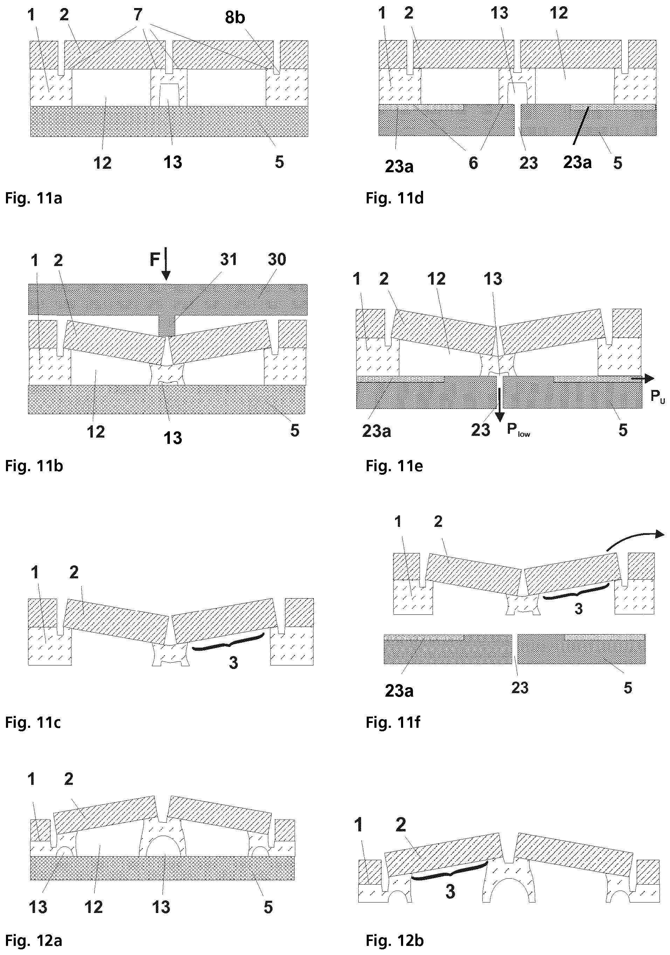

Die erforderlichen Druckunterschiede können alternativ durch Verwendung einer entsprechenden Auflage 5 mit ein oder mehreren Entlüftungskanälen 23 und Ausgleichskanälen 23a eingestellt werden, wie in Fig. 11d-11f gezeigt wird. Die Ausgleichskanäle 23a stellen dabei eine Verbindung der Hohlräume 12 zur Umgebung her, um eine Druckdifferenz zu vermeiden beziehungsweise zu reduzieren beziehungsweise zu minimieren. Über den Entlüftungskanal 23 wird mittels Vakuumpumpe im Hohlraum 13 ein Druck eingestellt, der unter dem Umgebungsdruck liegt.

Die Formgebung unterstützend und entsprechend zusätzlich zur Krafteinbringung unter Verwendung einer Druckdifferenz oder alleinig wirkend (ohne Krafteinbringung auf Basis einer Druckdifferenz) kann, wie bereits beschrieben, auch in diesen Fällen eine spezielle Formgebungsvorrichtung 30 eingesetzt werden (Fig. 11b).

Die Fig. 12a-12b zeigen zudem ein Ausführungsbeispiel, bei dem mehrere unterschiedlich gestaltete und/oder mit unterschiedlichen Drücken beaufschlagte Hohlräume 13 zwischen dem Glaswafer 1 und dem Siliziumwafer 5 verwendet werden, um lokal unterschiedlich starke Auslenkungen der Funktionselemente 2 und damit ein Neigen beziehungsweise ein Neigen und Verschieben der Funktionselemente 2 beziehungsweise der optischen Fenster 3 zu erreichen.

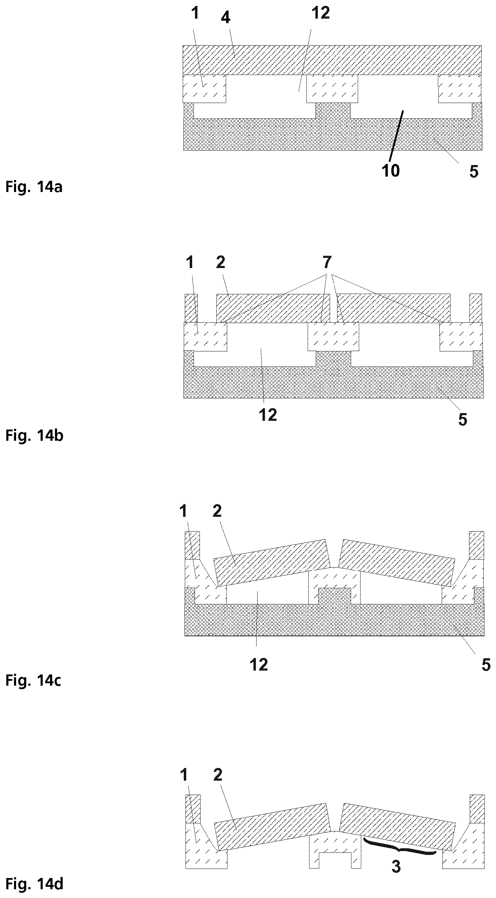

Die Fig. 14a-14d zeigen die Schrittfolge eines weiteren Ausführungsbeispiels zur Herstellung eines Deckelarrays 22 mit geneigten und verschobenen optischen Fenstern 3 nach dem erfindungsgemäßen Verfahren unter Verwendung von Vertiefungen 10 im Träger 5, wobei im Vergleich zum Umgebungsdruck ein Unterdruck in den Hohlräumen 12 zur Krafteinbringung und zur Bedingung der Verformung eingestellt wird.

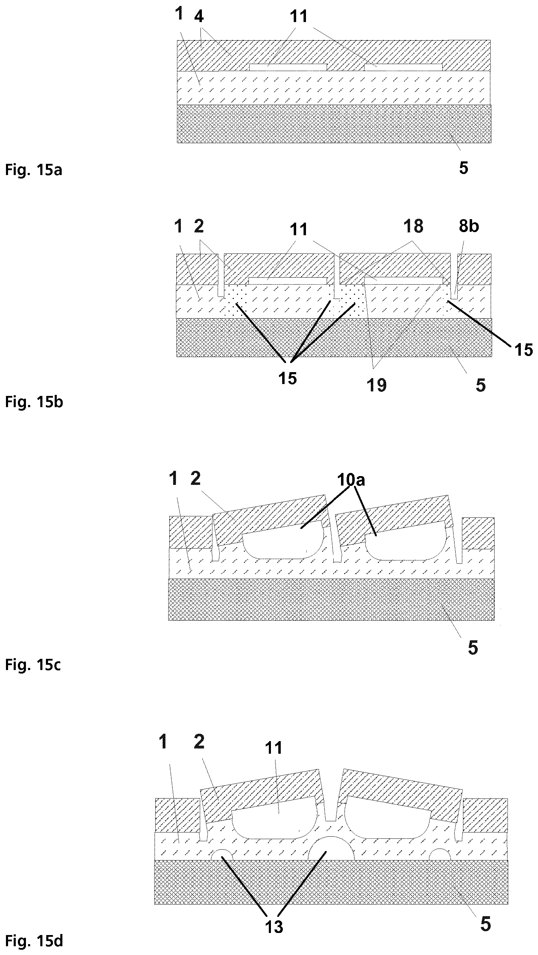

Die Fig. 15a-15d zeigen die Schrittfolge eines weiteren Ausführungsbeispiels zur Herstellung eines Deckelarrays 22 mit geneigten und verschobenen optischen Fenstern 3 nach dem erfindungsgemäßen Verfahren unter Verwendung von Hohlräumen 11 zwischen dem Verformungselement 1 (ein Glaswafer aus Borsilikatglas) und den Funktionselementen 2. Die Basis für die Hohlräume 11 stellen Funktionselemente 2 dar, die Vertiefungen 10a aufweisen. Durch einen im Vergleich zum Umgebungsdruck in den Hohlräumen 11 eingestellten Überdruck werden die Funktionselemente 2 vom Glaswafer 1 weggedrückt (Fig. 15c). Zusätzlich zu den Hohlräumen 11 können Hohlräume 13 vorgesehen werden (Fig. 15d), wodurch eine zusätzliche druckbedingte Krafteinbringung gewährleistet werden kann.

Durch die bereichsweise unterschiedliche Gestaltung des Verformungsbereichs beziehungsweise der Verformungsbereiche 15 (Fig. 15b) wird ein Neigen der Funktionselemente 2 erreicht. Nach dem Entfernen des Siliziumwafers 5 werden durch Schleifen und/oder Polieren die Hohlräume 11 beziehungsweise die Hohlräume 13 geöffnet.

In einer abgewandelten Prozessvariante kann auf die Hohlräume 11 (Fig. 15b) verzichtet werden. In diesem Fall kann eine Krafteinbringung beispielsweise durch eine magnetische Wechselwirkung erfolgen. Die lokalen Unterschiede im Verformungswiderstand der Verformungsbereiche 15 zur Unterstützung eines Neigens der Funktionselemente 2 werden unter anderem dadurch gewährleistet, dass der Kontakt zwischen den Funktionselementen 2 und dem Glaswafer 1 lediglich in den Bereichen zu einer Verbindung führt, in denen die eingebrachte Kraft von den Funktionselementen 2 auf den Glaswafer 1 zur Erzielung der gewünschten Verformung übertragen werden soll. In den nicht miteinander verbundenen Kontaktbereichen zwischen Glaswafer 1 und Funktionselementen 2 wird durch die Verformung der Verformungsbereiche 15 der Kontakt zwischen den Funktionselementen 2 und dem Glaswafer 1 aufgehoben und so ein Hohlraum 11 zwischen den Funktionselementen 2 und dem Glaswafer 1 erzeugt; äquivalent zu der Darstellung in Fig. 15c, allerdings ohne Vertiefungen 10a in den Funktionselementen 2.

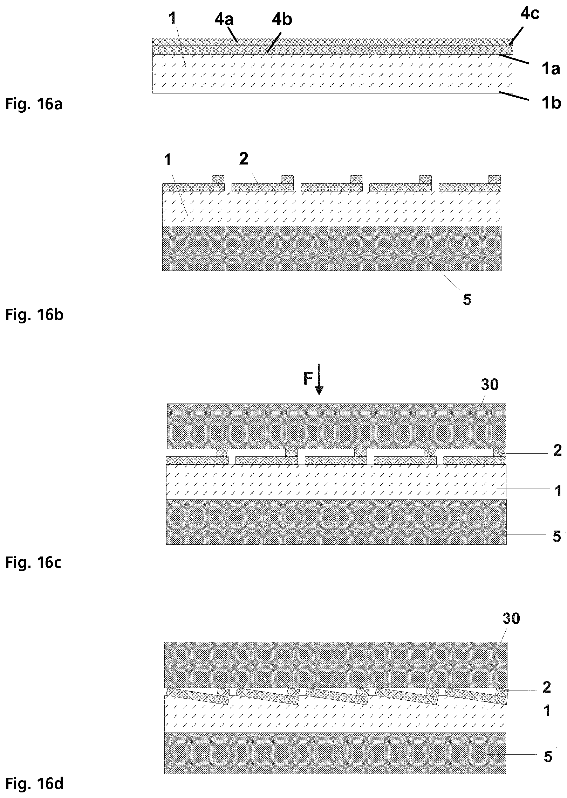

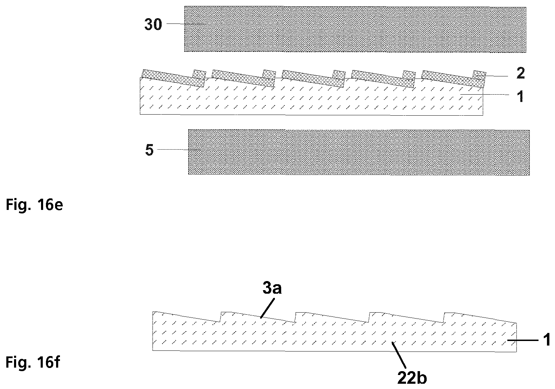

Die Fig. 16a-16f zeigen ein Ausführungsbeispiel zur Strukturierung eines beidseitig ebenen Glaswafers 1 aus Borsilikatglas mit einer Dicke von 725 µm, um ein oder mehrere Prismen oder geneigte Spiegel herzustellen. Zur Herstellung eines Prismenarrays wird dabei auf die eine Waferseite 1a des beidseitig ebene Substratflächen 1a, 1b aufweisenden Glaswafers 1 eine Schichtfolge aus zwei jeweils 200 µm dicken Siliziumschichten 4a, 4b und einer dazwischen gelagerten 1 µm dicken Siliziumdioxidschicht 4c aufgebracht beziehungsweise abgeschieden. Durch Strukturierung der Schichtfolge 4a, 4b, 4c werden Funktionselemente 2 erzeugt (Fig. 16b). Durch die Verwendung einer solchen Schichtfolge kann die Genauigkeit der Strukturierung zur Erzeugung der Funktionselemente 2 verbessert werden. Alternativ kann eine 400 µm dicke Siliziumschicht als Funktionsschicht 4 aufgebracht beziehungsweise abgeschieden und anschließend strukturiert werden. Die Funktionselemente 2 können sowohl die Funktion eines Formgebungselements als auch eines Schutz- und/oder Abformelements erfüllen. Als Formgebungselement übertragen beziehungsweise verteilen diese Funktionselemente 2 die eingebrachte Kraft auf den Glaswafer 1, wodurch dieser verformt wird. Als Schutzelement können die Funktionselemente 2 die bereitgestellte hohe Oberflächenqualität des Glaswafers 1 konservieren. Als Abformelement kann andererseits eine hohe Oberflächenqualität der Funktionselemente 2 auf den Glaswafer 1 abgeformt beziehungsweise übertragen werden. Durch Inkontaktbringen einer Formgebungsvorrichtung 30 aus Quarzglas mit der strukturierten Siliziumschicht 4a wird die Kraft zur Verformung des Glaswafers 1 eingebracht (Fig. 16c). Durch die asymmetrische Strukturierung der beiden Siliziumschichten 4a, 4b wird ein Neigen der Funktionselemente 2 erreicht (Fig. 16d). Zudem können die Funktionselemente 2 auf Grund der Strukturierung die Funktionalität eines Anschlags übernehmen, da beim Erreichen der gewünschten Neigung der Funktionselemente 2 die Formgebungsvorrichtung 30 mit der strukturierten Siliziumschicht 4b in Kontakt tritt und ein weiteres Neigen verhindert wird (Fig. 16d). Nach dem Entfernen der Formgebungsvorrichtung 30 und dem Entfernen der Funktionselemente 2 kann der strukturierte Glaswafer 1 als Prismenarray verwendet oder zu mehreren Prismen vereinzelt werden.

Im Falle der Herstellung eines Spiegelarrays kann nach dem Erwärmen und Verformen auf die Funktionselemente 2 oder auf den strukturierten Glaswafer 1 beziehungsweise seine geneigten Transmissionsflächen 3a eine Aluminiumschicht als Reflexionsbeschichtung abgeschieden werden.

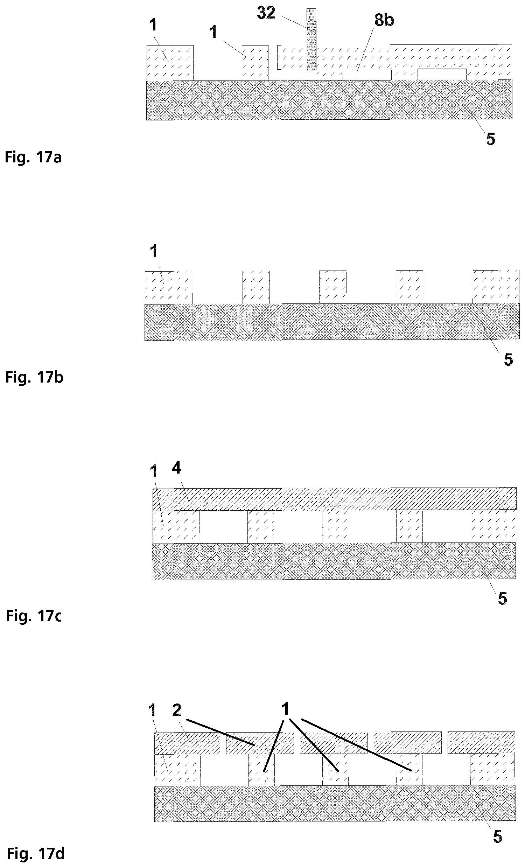

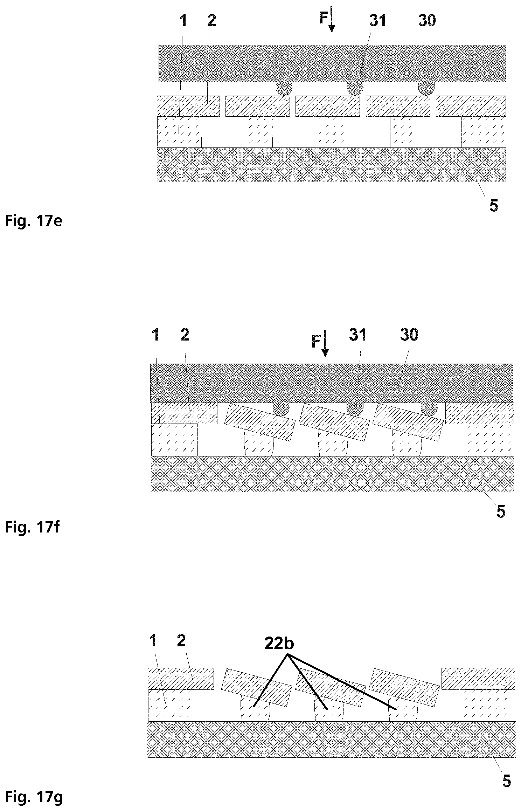

Ein weiteres Ausführungsbeispiel zur Herstellung von ein oder mehreren Prismen oder geneigten Spiegeln nach dem erfindungsgemäßen Verfahren zeigen die Fig. 17a-17g. Nachdem ein Glaswafer 1 aus Borsilikatglas, der Vertiefungen 8b aufweist, die beim folgenden Sägeschritt zur Erzeugung von Inselstrukturen 1 einen Kontakt der Säge 32 mit dem Siliziumwafer 5 verhindern sollen, auf einen Siliziumwafer 5 mittels Fusion Bonding gebondet wurde, werden aus dem Glaswafer 1 in einem Sägeschritt einzelne Inselstrukturen (Fig.17a-17b) als Verformungselemente 1 erzeugt. Alternativ können die Inselstrukturen 1 vor dem Verbinden mit dem Siliziumwafer 5 erzeugt (zum Beispiel durch Sägen) und mittels Vakuumhandler auf dem Siliziumwafer 5 angeordnet werden. Durch Verbinden eines Quarzglaswafers 4 mit den Inselstrukturen 1 (Fig. 17c) und anschließender Strukturierung des Quarzglaswafers 4 mittels Sägens werden mehrere Funktionselemente 2 erzeugt (Fig.17d), wobei die Erzeugung der Funktionselement 2 alternativ wiederum vor dem Verbinden mit den Inselstrukturen 1 erfolgen kann. Im Ergebnis steht jede Inselstruktur 1 mit einem Funktionselement 2 in Verbindung; aber es können auch mehrere Inselstrukturen 1, die zum Beispiel in einer Reihe beziehungsweise Spalte angeordnet sind, mit einem Funktionselement 2 verbunden werden.

Die Verformungskraft wird mittels Formgebungsvorrichtung 30 eingebracht (Fig. 17e), so dass ein Neigen der Funktionselemente 2 bewirkt wird (Fig. 17f).

Wurden die Funktionselemente 2 mit einer reflektierenden Veredelungsbeschichtung versehen, können die erzeugten optischen Komponenten beispielsweise als geneigte Spiegel verwendet werden. Alternativ stehen nach Entfernung der Funktionselemente 2 und/oder des Siliziumwafers 5 Prismen als optische Komponenten zur Verfügung.

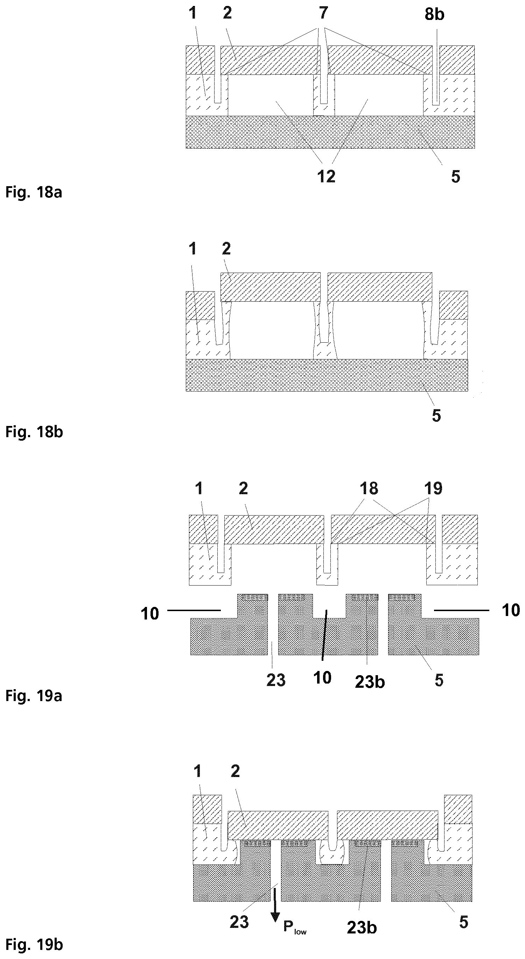

In den Fig. 18a-18b und Fig. 19a-19b sind zwei Ausführungsbeispiele dargestellt, die die Herstellung eines Deckelarrays 22 nach dem erfindungsgemäßen Verfahren mit verschobenen optischen Fenstern 3 zeigen.

In beiden Beispielen erfolgt das Einbringen der Kraft für die Verformung wiederum auf Basis einer Druckdifferenz zwischen dem Druck in den Hohlräumen 12, im Beispiel Fig. 18a-18b ein Überdruck und im Beispiel Fig. 19a-19b ein Unterdruck, und dem Umgebungsdruck. Durch eine widerstandssymmetrische Auslegung des Verformungsbereichs 15 wird ein Neigen der optischen Fenster 3 durch die Verformung des Borsilikatglaswafers 1 vermieden und ein verschieben erreicht.

Gemäß Ausführungsbeispiel Fig. 19a-19b erfolgt die Einstellung des Drucks in den Hohlräumen 12 nicht im Rahmen der vorherigen Verbindungsschritte sondern durch Entlüftungskanäle 23 und Entlüftungsvertiefungen 23b, die eine flächige Entlüftung verbessern, in der Auflage 5, über die mittels Vakuumpumpe der gewünschte Druck eingestellt wird. Durch Vertiefungen 10 in der Auflage 5 kann die gewünschte Auslenkung der optischen Fenster 3 eingestellt werden, wobei die Auflage 5 als Auslenkungsbegrenzung fungiert. Dadurch lassen sich besonders präzise optische Komponenten fertigen.

### Bezugszeichenliste

- 1: Verformungselement
- 1a, 1b: Waferseiten beziehungsweise Substratflächen des Verformungselements
- 2: Funktionselement
- 3: optisches Fenster
- 3a: Transmissionsfläche zum Beispiel des optischen Fensters oder des Prismas
- 4: Funktionssubstrat beziehungsweise Funktionsschicht
- 4a, 4b: Siliziumschichten
- 4c: Siliziumoxidschicht
- 5: Träger (zum Beispiel Siliziumsubstrat, Graphitauflage)
- 6: erste Kontaktfläche
- 7: zweite Kontaktfläche
- 8a: Öffnung im Verformungselement
- 8b: Vertiefung im Verformungselement
- 8c: Vertiefung für Stabilisierungsschicht
- 9: Behelfsvertiefung
- 10: Vertiefung im Träger
- 10a: Vertiefung im Funktionselement
- 11: Hohlraum zwischen Funktionselement oder Funktionssubstrat/-schicht und Verformungselement
- 12: Hohlraum zwischen Funktionselement oder Funktionssubstrat/-schicht, Verformungselement und Träger
- 13: Hohlraum zwischen Verformungselement und Träger
- 14: Hohlraum auf Basis der Behelfsvertiefung
- 15: Verformungsbereich
- 16a: überlappender Bereich der ersten Kontaktfläche
- 16b: überlappender Bereich der zweiten Kontaktfläche
- 17: Oberflächenbereich des Verformungsbereichs
- 18: äußerer Rand der zweiten Kontaktfläche
- 19: innerer Rand der zweiten Kontaktfläche
- 20: Stabilisierungsschicht
- 21: Unterstützungsstruktur des Trägers
- 22: Deckel beziehungsweise Deckelarray
- 22a: Kontaktierungsfläche des Deckels beziehungsweise Deckelarrays
- 22b: Array von Prismen oder geneigten Spiegeln
- 23: Entlüftungskanal oder Belüftungskanal
- 23a: Ausgleichskanal
- 23b: Entlüftungsvertiefung
- 24: Trägersubstrat
- 25: Mikrospiegel
- 26: Aufhängung des Mikrospiegels
- 27: Kontaktpads
- 28: einfallende Strahlung
- 29: abgelenkte Strahlung
- 30: Formgebungsvorrichtung
- 31: Stempelelement zum Beispiel mit gerader, schräger, keil- oder konusförmiger Stempelfläche
- 32: Säge
- 33: Rahmensegment

## Patentansprüche

1. Verfahren zur Herstellung optischer Komponenten mit den folgenden Verfahrensschritten:
- Bereitstellen eines Verformungselements (1), das zumindest in einem Bereich Glas und/oder ein glasähnliches Material enthält oder daraus besteht, und eines Trägers (5),
- in Kontakt bringen des Verformungselements (1) mit dem Träger (5), wodurch mindestens eine erste Kontaktfläche (6) zwischen dem Verformungselement (1) und dem Träger (5) gebildet wird,
- Aufbringen eines Funktionselements (2) auf dem Verformungselement (1) derart, dass zwischen dem Funktionselement (2) und dem Verformungselement (1) mindestens eine zweite Kontaktfläche (7) gebildet wird, die die erste Kontaktfläche (6) zumindest teilweise überlappt, so dass durch den Bereich des Verformungselements (1), der zwischen den sich überlappenden Bereichen (16a, 16b) der beiden Kontaktflächen (6, 7) ausgebildet ist, mindestens ein Verformungsbereich (15) gebildet wird,
- Erwärmen und Verformen zumindest eines Teils des Verformungsbereichs (15) derart, dass sich das Funktionselement (2) in Relation zum Träger (5) zumindest bereichsweise verschiebt und/oder neigt,
- Verbinden des Funktionselements (2) mit dem Verformungselement (1) beim Verfahrensschritt des Aufbringens des Funktionselements (2) auf dem Verformungselement (1) und/oder beim Verfahrensschritt des Erwärmen und Verformens des Verformungsbereichs (15),
**dadurch gekennzeichnet, dass**
A) das Verformungselement (1) ein Wafer ist oder dass das Verformungselement (1) durch Abtrennen und/oder durch Strukturieren von einem Wafer bereitgestellt wird,
und
B) dass der Verformungsbereich (15) rahmenförmig ausgebildet ist und/oder mindestens zwei Verformungsbereiche (15) ausgebildet sind, die mit demselben Funktionselement (2) in Kontakt sind, und/oder dass der überlappende Bereich der zweiten Kontaktfläche (16b) etwa der zweiten Kontaktfläche (7) entspricht.

2. Verfahren nach Anspruch 1, **dadurch gekennzeichnet, dass** das Verformungselement (1) zumindest in einem Bereich ein Silikatglas, bevorzugt Borsilikatglas, enthält oder daraus besteht.

3. Verfahren nach einem der vorhergehenden Ansprüche, **dadurch gekennzeichnet, dass** das Funktionselement (2), das Verformungselement (1) und/oder der Träger (5) eine Vertiefung und/oder Öffnung (8a, 8b, 10, 10a) aufweist.

4. Verfahren nach Anspruch 3, **dadurch gekennzeichnet, dass** das Inkontaktbringen des Verformungselements (1) mit dem Träger (5) und/oder das Aufbringen des Funktionselements (2) auf dem Verformungselement (1) derart erfolgt, dass durch die Vertiefung und/oder Öffnung (8a, 8b, 10, 10a) ein Hohlraum (13, 11, 12) zwischen dem Verformungselement (1) und dem Träger (5), zwischen dem Verformungselement (1) und dem Funktionselement (2) und/oder zwischen dem Funktionselement (2), dem Verformungselement (1) und dem Träger (5) gebildet wird, wobei der Hohlraum (13, 11, 12) insbesondere hermetisch abgeschlossen ist.

5. Verfahren nach einem der vorhergehenden Ansprüche, **dadurch gekennzeichnet, dass** die Differenz des thermischen Ausdehnungskoeffizienten des Materials des Verformungselements (1) und des thermischen Ausdehnungskoeffizienten des Materials des Funktionselements (2) kleiner gleich 5 ppm/°K, insbesondere kleiner gleich 1 ppm/°K, ist.

6. Verfahren nach einem der vorhergehenden Ansprüche, **dadurch gekennzeichnet, dass** zumindest ein Bereich der Oberfläche des Funktionselements (2) eine quadratische Oberflächenrauigkeit kleiner gleich 25 nm, bevorzugt kleiner gleich 15 nm, besonders bevorzugt kleiner gleich 5 nm, und/oder eine Ebenheitsabweichung pro gemessener Länge kleiner gleich 180 nm/mm, insbesondere kleiner gleich 100 nm/mm, aufweist.

7. Verfahren nach einem der vorhergehenden Ansprüche, **dadurch gekennzeichnet, dass** die sich überlappenden Bereiche (16a, 16b) der ersten (6) und/oder zweiten Kontaktfläche (7) rahmenförmig, insbesondere um die Vertiefung und/oder Öffnung (8a, 8b) im Verformungselement (1), ausgebildet sind und/oder der Verformungsbereich (15) rahmenförmig um die Vertiefung und/oder Öffnung (8a, 8b) im Verformungselement (1) ausgebildet ist und/oder dass die mindestens zwei Verformungsbereiche (15) diametral um die Vertiefung und/oder Öffnung (8a, 8b) im Verformungselement (1) ausgebildet sind.

8. Verfahren nach einem der vorhergehenden Ansprüche, **dadurch gekennzeichnet, dass** der Verformungsbereich (15) eine Oberfläche (17) aufweist, wobei insbesondere die zwei Segmente (33) des rahmenförmigen Verformungsbereichs (15) und/oder die zwei Verformungsbereiche (15) und/oder die zwei Verformungsteilbereiche Oberflächen (17) mit unterschiedlich großem Flächeninhalt aufweisen.

9. Verfahren nach Anspruch 8, **dadurch gekennzeichnet, dass** die Oberfläche (17) des Verformungsbereichs (15) durch Strukturierung des Verformungselements (1), insbesondere durch Sägen und/oder Ätzen, erzeugt und/oder vergrößert wird.

10. Verfahren nach einem der Ansprüche 7 bis 9, **dadurch gekennzeichnet, dass** der Flächeninhalt der jeweiligen Bereiche der ersten (6) und/oder zweiten Kontaktfläche (7), die die zwei Segmente des rahmenförmigen Verformungsbereichs (15) und/oder die zwei Verformungsbereiche (15) und/oder die zwei Verformungsteilbereiche begrenzen, unterschiedlich groß sind.

11. Verfahren nach einem der Ansprüche 7 bis 10, **dadurch gekennzeichnet, dass** der äußere Rand (18) des rahmenförmigen sich überlappenden Bereichs (16a, 16b) der ersten (6) und/oder zweiten Kontaktfläche (7) eine erste geometrische Figur und der innere Rand (19) eine zweite geometrische Figur beschreibt, wobei die erste und die zweite geometrische Figur unabhängig voneinander jeweils ausgewählt sind aus der Gruppe bestehend aus Rechteck, Trapez, insbesondere gleichschenkliges oder rechtwinkliges Trapez, Kreis und Dreieck.

12. Verfahren nach einem der vorhergehenden Ansprüche, **dadurch gekennzeichnet, dass** ein Bereich des Verformungselements (1) mit einer Stabilisierungsschicht (20) versehen wird, die der Verformung des Verformungsbereichs (15) entgegenwirkt.

13. Verfahren nach einem der vorhergehenden Ansprüche, **dadurch gekennzeichnet, dass** die obere Kühltemperatur oder die Solidustemperatur des Materials des Funktionselements (2) größer als die obere Kühltemperatur oder die Solidustemperatur des Materials des Verformungsbereichs (15) ist, wobei die Temperaturdifferenz zwischen der jeweiligen Kühltemperatur oder Solidustemperatur des Materials des Funktionselements (2) und des Materials des Verformungsbereichs (15) insbesondere größer gleich 100K ist.

14. Verfahren nach einem der vorhergehenden Ansprüche, **dadurch gekennzeichnet, dass** zumindest ein Teil des Verformungsbereichs (15), insbesondere der gesamte Verformungsbereich (15), während des Verfahrensschritts des Erwärmen und Verformens auf eine Temperatur gebracht wird, die oberhalb der oberen Kühltemperatur oder Solidustemperatur des Materials des Verformungsbereichs (15) und unterhalb der oberen Kühltemperatur oder Solidustemperatur des Materials des Funktionselements (2) liegt.

15. Verfahren nach einem der vorhergehenden Ansprüche, **dadurch gekennzeichnet, dass** der Träger (5) eine Unterstützungsstruktur (21) aufweist, die einen Bereich des Funktionselements (2) und/oder einen Bereich des Verformungselements (1) derart in seiner Auslenkbarkeit und/oder Verformbarkeit beschränkt, dass ein Neigen des Funktionselements (2) unterstützt wird.

## Claims

1. Method for producing optical components, comprising the following method steps:
- providing a deformation element (1) which, at least in one region, contains or consists of glass and/or a glass-like material, and a carrier (5),
- bringing the deformation element (1) into contact with the carrier (5), whereby at least one first contact surface (6) is formed between the deformation element (1) and the carrier (5),
- applying a functional element (2) to the deformation element (1) in such a way that at least one second contact surface (7) is formed between the functional element (2) and the deformation element (1), said at least one second contact surface (7) at least partially overlapping the first contact surface (6), so that, by way of that region of the deformation element (1) which is formed between the overlapping regions (16a, 16b) of the two contact surfaces (6, 7), at least one deformation region (15) is formed,
- heating and deforming at least a part of the deformation region (15) in such a way that the functional element (2) is at least regionally displaced and/or inclined in relation to the carrier (5),
- connecting the functional element (2) to the deformation element (1) during the method step of applying the functional element (2) to the deformation element (1) and/or during the method step of heating and deforming the deformation region (15),
**characterized in that**
A) the deformation element (1) is a wafer, or **in that** the deformation element (1) is provided by separation from and/or by structuring of a wafer,
and
B) **in that** the deformation region (15) is of frame-shaped form and/or there are formed at least two deformation regions (15) which are in contact with the same functional element (2), and/or **in that** the overlapping region of the second contact surface (16b) corresponds approximately to the second contact surface (7).

2. Method according to Claim 1, **characterized in that**, at least in one region, the deformation element (1) contains or consists of a silicate glass, preferably borosilicate glass.

3. Method according to any one of the preceding claims, **characterized in that** the functional element (2), the deformation element (1) and/or the carrier (5) have/has a depression and/or opening (8a, 8b, 10, 10a).

4. Method according to Claim 3, **characterized in that** the deformation element (1) is brought into contact with the carrier (5) and/or the functional element (2) is applied to the deformation element (1) in such a way that, by way of the depression and/or opening (8a, 8b, 10, 10a), a cavity (13, 11, 12) is formed between the deformation element (1) and the carrier (5), between the deformation element (1) and the functional element (2) and/or between the functional element (2), the deformation element (1) and the carrier (5), wherein the cavity (13, 11, 12) is in particular hermetically sealed.

5. Method according to any one of the preceding claims, **characterized in that** the difference between the coefficient of thermal expansion of the material of the deformation element (1) and the coefficient of thermal expansion of the material of the functional element (2) is less than or equal to 5 ppm/°K, in particular less than or equal to 1 ppm/°K.

6. Method according to any one of the preceding claims, **characterized in that** at least one region of the surface of the functional element (2) has a root-mean-square surface roughness of less than or equal to 25 nm, preferably less than or equal to 15 nm, particularly preferably less than or equal to 5 nm, and/or a flatness deviation per measured length of less than or equal to 180 nm/mm, in particular less than or equal to 100 nm/mm.

7. Method according to any one of the preceding claims, **characterized in that** the overlapping regions (16a, 16b) of the first contact surface (6) and/or second contact surface (7) are of frame-shaped form, in particular are formed around the depression and/or opening (8a, 8b) in the deformation element (1), and/or the deformation region (15) is formed in a frame-shaped manner around the depression and/or opening (8a, 8b) in the deformation element (1), and/or **in that** the at least two deformation regions (15) are formed diametrically around the depression and/or opening (8a, 8b) in the deformation element (1).

8. Method according to any one of the preceding claims, **characterized in that** the deformation region (15) has a surface (17), wherein in particular the two segments (33) of the frame-shaped deformation region (15) and/or the two deformation regions (15) and/or the two deformation sub-regions have surfaces (17) with surface areas of different sizes.

9. Method according to Claim 8, **characterized in that** the surface (17) of the deformation region (15) is produced and/or enlarged by structuring of the deformation element (1), in particular by sawing and/or etching.

10. Method according to any one of Claims 7 to 9, **characterized in that** the surface areas of the respective regions of the first contact surface (6) and/or second contact surface (7) that delimit the two segments of the frame-shaped deformation region (15) and/or the two deformation regions (15) and/or the two deformation sub-regions are of different sizes.

11. Method according to any one of Claims 7 to 10, **characterized in that** the outer periphery (18) of the frame-shaped overlapping region (16a, 16b) of the first contact surface (6) and/or second contact surface (7) describes a first geometrical figure and the inner periphery (19) describes a second geometrical figure, wherein the first and second geometrical figures are, independently of one another, in each case selected from the group consisting of rectangle, trapezium, in particular isosceles or right trapezium, circle and triangle.

12. Method according to any one of the preceding claims, **characterized in that** one region of the deformation element (1) is provided with a stabilization layer (20) which counteracts the deformation of the deformation region (15).

13. Method according to any one of the preceding claims, **characterized in that** the upper cooling temperature or the solidus temperature of the material of the functional element (2) is greater than the upper cooling temperature or the solidus temperature of the material of the deformation region (15), wherein the temperature difference between the respective cooling temperature or solidus temperature of the material of the functional element (2) and that of the material of the deformation region (15) is in particular greater than or equal to 100K.

14. Method according to any one of the preceding claims, **characterized in that** at least a part of the deformation region (15), in particular the entire deformation region (15), is, during the method step of heating and deforming, brought to a temperature which is above the upper cooling temperature or solidus temperature of the material of the deformation region (15) and below the upper cooling temperature or solidus temperature of the material of the functional element (2).

15. Method according to any one of the preceding claims, **characterized in that** the carrier (5) has a support structure (21) which limits a region of the functional element (2) and/or a region of the deformation element (1) in terms of the ability thereof to deflect and/or deform in such a way that inclination of the functional element (2) is supported.

## Revendications

1. Procédé de fabrication de composants optiques avec les étapes de procédé suivantes :
- fourniture d'un élément de déformation (1), qui contient au moins dans une zone du verre et/ou un matériau similaire au verre ou en est constitué, et d'un support (5),
- mise en contact de l'élément de déformation (1) avec le support (5), ce qui permet de former au moins une première surface de contact (6) entre l'élément de déformation (1) et le support (5),
- mise en place d'un élément fonctionnel (2) sur l'élément de déformation (1) de manière à former, entre l'élément fonctionnel (2) et l'élément de déformation (1), au moins une deuxième surface de contact (7), qui chevauche au moins en partie la première surface de contact (6) de telle sorte qu'au moins une zone de déformation (15) est formée par la zone de l'élément de déformation (1), qui est réalisée entre les zones (16a, 16b) se chevauchant des deux surfaces de contact (6, 7),
- chauffage et déformation d'au moins une partie de la zone de déformation (15) de telle manière que l'élément fonctionnel (2) est déplacé et/ou incliné au moins par endroits par rapport au support (5),
- liaison de l'élément fonctionnel (2) à l'élément de déformation (1) lors de l'étape de procédé de la mise en place de l'élément fonctionnel (2) sur l'élément de déformation (1) et/ou lors de l'étape de procédé du chauffage et de la déformation de la zone de déformation (15),
**caractérisé en ce que**
A) l'élément de déformation (1) est une tranche ou **en ce que** l'élément de déformation (1) est fourni par séparation et/ou par structuration d'une tranche,
et
B) **en ce que** la zone de déformation (15) est réalisée en forme de cadre et/ou au moins deux zones de déformation (15) sont réalisées, qui sont en contact avec le même élément fonctionnel (2), et/ou **en ce que** la zone de chevauchement de la deuxième surface de contact (16b) correspond à peu près à la deuxième surface de contact (7).

2. Procédé selon la revendication 1, **caractérisé en ce que** l'élément de déformation (1) contient au moins dans une zone un verre de silicate, de manière préférée un verre de borosilicate, ou en est constitué.

3. Procédé selon l'une des revendications précédentes, **caractérisé en ce que** l'élément fonctionnel (2), l'élément de déformation (1) et/ou le support (5) comportent un renfoncement et/ou une ouverture (8a, 8b, 10, 10a).

4. Procédé selon la revendication 3, **caractérisé en ce que** la mise en contact de l'élément de déformation (1) avec le support (5) et/ou la mise en place de l'élément fonctionnel (2) sur l'élément de déformation (1) sont effectuées de manière à former, par le renfoncement et/ou l'ouverture (8a, 8b, 10, 10a), une cavité (13, 11, 12) entre l'élément de déformation (1) et le support (5), entre l'élément de déformation (1) et l'élément fonctionnel (2) et/ou entre l'élément fonctionnel (2), l'élément de déformation (1) et le support (5), la cavité (13, 11, 12) étant en particulier fermée hermétiquement.

5. Procédé selon l'une des revendications précédentes, **caractérisé en ce que** la différence du coefficient de dilatation thermique du matériau de l'élément de déformation (1) et du coefficient de dilatation thermique du matériau de l'élément fonctionnel (2) est inférieure ou égale à 5 ppm/°K, en particulier inférieure ou égale à 1 ppm/°K.

6. Procédé selon l'une des revendications précédentes, **caractérisé en ce qu'**au moins une zone de la surface de l'élément fonctionnel (2) présente une rugosité quadratique de surface inférieure ou égale à 25 nm, de manière préférée inférieure ou égale à 15 nm, de manière particulièrement préférée inférieure ou égale à 5 nm, et/ou un écart de planéité par longueur mesurée inférieur ou égal à 180 nm/mm, en particulier inférieur ou égal à 100 nm/mm.

7. Procédé selon l'une des revendications précédentes, **caractérisé en ce que** les zones (16a, 16b) se chevauchant de la première (6) et/ou de la deuxième surface de contact (7) sont réalisées en forme de cadre, en particulier autour du renfoncement et/ou de l'ouverture (8a, 8b) dans l'élément de déformation (1) et/ou la zone de déformation (15) est réalisée en forme de cadre autour du renfoncement et/ou de l'ouverture (8a, 8b) dans l'élément de déformation (1), et/ou **en ce que** les au moins deux zones de déformation (15) sont réalisées diamétralement autour du renfoncement et/ou de l'ouverture (8a, 8b) dans l'élément de déformation (1).

8. Procédé selon l'une des revendications précédentes, **caractérisé en ce que** la zone de déformation (15) comporte une surface (17), en particulier les deux segments (33) de la zone de déformation (15) en forme de cadre et/ou les deux zones de déformation (15) et/ou les deux zones partielles de déformations comportant des surfaces (17) avec une superficie de grandeur différente.

9. Procédé selon la revendication 8, **caractérisé en ce que** la surface (17) de la zone de déformation (15) est produite et/ou agrandie par structuration de l'élément de déformation (1), en particulier par sciage et/ou attaque chimique.

10. Procédé selon l'une des revendications 7 à 9, **caractérisé en ce que** la superficie des zones respectives de la première (6) et/ou de la deuxième surface de contact (7), qui délimitent les deux segments de la zone de déformation (15) en forme de cadre et/ou les deux zones de déformation (15) et/ou les deux zones partielles de déformation, sont de grandeur différente.

11. Procédé selon l'une des revendications 7 à 10, **caractérisé en ce que** le bord extérieur (18) de la zone (16a, 16b) se chevauchant en forme de cadre de la première (6) et/ou de la deuxième surface de contact (7) décrit une première figure géométrique et le bord intérieur (19) décrit une deuxième figure géométrique, la première et la deuxième figure géométrique étant choisies chacune indépendamment l'une de l'autre dans le groupe comprenant le rectangle, le trapèze, en particulier un trapèze isocèle ou rectangle, le cercle et le triangle.

12. Procédé selon l'une des revendications précédentes, **caractérisé en ce qu'**une zone de l'élément de déformation (1) est pourvue d'une couche de stabilisation (20), qui correspond à la déformation de la zone de déformation (15).

13. Procédé selon l'une des revendications précédentes, **caractérisé en ce que** la température de refroidissement supérieur ou la température solidus du matériau de l'élément fonctionnel (2) est supérieure à la température de refroidissement supérieure ou à la température solidus du matériau de la zone de déformation (15), la différence de température entre la température de refroidissement respective ou la température solidus du matériau de l'élément fonctionnel (2) et du matériau de la zone de déformation (15) étant en particulier supérieure ou égale à 100 K.

14. Procédé selon l'une des revendications précédentes, **caractérisé en ce qu'**au moins une partie de la zone de déformation (15), en particulier la totalité de la zone de déformation (15), est amenée, pendant l'étape de procédé du chauffage et de la déformation, à une température qui se situe au-dessus de la température de refroidissement supérieure ou de la température solidus du matériau de la zone de déformation (15) et en dessous de la température de refroidissement supérieure ou de la température solidus du matériau de l'élément fonctionnel (2).

15. Procédé selon l'une des revendications précédentes, **caractérisé en ce que** le support (5) comporte une structure de soutien (21), qui restreint la capacité de déviation et/ou la capacité de déformation d'une zone de l'élément fonctionnel (2) et/ou d'une zone de l'élément de déformation (1) de manière à soutenir une inclinaison de l'élément fonctionnel (2).
